# EUROPEAN PATENT SPECIFICATION

(11) **EP 1 905 804 B1**
(45) Date of publication and mention of the grant of the patent: **07.08.2013**
(21) Application number: 06756687.7
(22) Date of filing: 29.05.2006
(51) Int. Cl.: C09K 11/06, C09D 179/08, C09D 5/24

(54) **CHARGE-TRANSPORTING VARNISHES CONTAINING CHARGE-TRANSPORTING POLYMERS AND ORGANIC ELECTROLUMINESCENT DEVICES MADE BY USING THE SAME**
LADUNGSTRANSPORTIERENDE LACKE MIT LADUNGSTRANSPORTIERENDEN POLYMEREN UND DAMIT HERGESTELLTE ORGANISCHE ELEKTROLUMINESZIERENDE VORRICHTUNGEN
VERNIS À TRANSPORT DE CHARGE CONTENANT DES POLYMÈRES À TRANSPORT DE CHARGE ET DISPOSITIFS ÉLECTROLUMINESCENTS ORGANIQUES RÉALISÉS À L'AIDE DESDITS VERNIS

(30) Priority: 03.06.2005 JP 2005163724; 22.09.2005 JP 2005275660
(43) Date of publication of application: 02.04.2008
(73) Proprietor: Nissan Chemical Industries, Ltd., Chiyoda-ku, Tokyo 101-0054 (JP)
(72) Inventor: ONO, Go, Nissan Chemical Industries, Ltd., Funabashi, Chiba 2748507 (JP); YAMADA, Tomohisa, Nissan Chemical Industries, Ltd., Funabashi, Chiba 2748507 (JP)
(74) Representative: Stoner, Gerard Patrick
(86) International application number: PCT/JP2006/310642
(87) International publication number: WO 2006/129589

(56) References cited:
- EP-A1- 1 403 325
- EP-A1- 1 728 827
- WO-A1-02/100949
- WO-A1-03/071559
- WO-A1-2005/092984
- JP-A- 06 338 392
- JP-A- 10 308 280
- JP-A- 10 308 280
- JP-A- 11 135 262
- JP-A- 2001 247 525
- JP-A- 2003 077 668
- JP-A- 2004 002 740
- JP-A- 2005 041 915
- JP-A- 2005 075 948
- JP-A- 2005 093 427
- JP-A- 2005 093 428
- JP-A- 2005 108 828
- US-A1- 2003 097 003
- US-A1- 2003 105 270
- GUEY-SHENG LIOU ET AL.: 'Synthesis and Properties of New Aromatic Poly(amino-imide)s Derived from N,N'-diphenyl-1,4-phenylenediamine' JOURNAL OF POLYMER SCIENCE PART. A POLYMER CHEMISTRY vol. 40, no. 21, 01 November 2002, pages 3815 - 3822, XP003004417
- KOTOV B.V. ET AL.: 'Photogeneration and photovoltaic properties of polyimides with extended charge delocalisation in polymer chains' SYNTHETIC MATERIALS vol. 121, no. 1 TO 3, 15 March 2001, pages 1553 - 1554, XP003004418
- GUEY-SHENG LIOU ET AL: "Synthesis and Properties of New Aromatic Poly(amino-imide)s Derived from N,N'-diphenyl-1,4-phenylenediamine", JOURNAL OF POLYMER SCIENCE. PART A, POLYMER CHEMISTRY, JOHN WILEY & SONS, INC, US, vol. 40, no. 21, 1 November 2002 (2002-11-01), pages 3815-3822, XP003004417, ISSN: 0887-624X, DOI: 10.1002/POLA.10430

## Description

### TECHNICAL FIELD

This invention relates to charge-transporting varnishes containing charge-transporting polymers for use in organic electroluminescent devices (hereinafter abbreviated as "EL") making use of the same.

### BACKGROUND ART

Since the finding of an organic EL device, which showed a characteristic property of 1,000 cd/m² or so at a drive voltage of 10 V or lower, by Tang et al. of Eastman Kodak Company in 1987 (see, for example, Non-Patent Document 1), active investigations have been made on organic EL devices. These organic EL devices can be roughly divided into low-molecular organic EL devices (hereinafter abbreviated as "OLED") and EL devices making use of polymer light-emitting materials (hereinafter abbreviated as "PLED". In general, both OLED and PLED use a hole injection layer and a hole transport layer to achieve improvements in initial characteristics and an increase in device operating life, such as lower drive voltage and higher luminescence efficiency.

As CuPC, a common hole-injecting material in OLED, is insoluble in various solvents (see, for example, Non-Patent Document 2), there is a need to form a film by vacuum evaporation. The film so formed is, however, accompanied by a drawback that its surfaces are markedly uneven and its material hence mixes in trace amounts in other organic layers to provide the resulting device with lowered characteristics. The film, therefore, cannot be used as a hole transport layer in PLED. It is also indicated that, because CuPC has an absorption in the visible range, it has low transparency and affects the tone of an emission from a device.

On the other hand, polyaniline materials (see, for example, Non-Patent Documents 3 and 4) and polythiophene materials (see, for example, Non-Patent Document 5), which are employed as hole transport layers in PLED, are often used as dispersions in organic solvents because they have low solubility in organic solvents. However, thin films formed with varnishes dispersed in organic solvents involve drawbacks that they have low mechanical strength and poor heat resistance. Moreover, the removal of a solvent tends to produce powder so that problems are developed in the uniformity and flatness of thin films. As a result, the generation of dark spots and the reductions in device characteristics due to anode-cathode short circuiting are promoted, thereby causing a reduction in yield upon fabrication of organic EL devices.

There is also an outstanding desire for the development of a device which, as an organic EL device, has high luminescence efficiency at low drive voltage and has good economy. To make an improvement in the luminescence efficiency of a device, a charge transport thin film is, therefore, required to be equipped with excellent charge transportability.

Non-Patent Document 1:
   Applied Physics Letters, 51, p. 913 to 915, 1987 (U.S.A.)
Non-Patent Document 2:
   Applied Physics Letters, 69, p. 2160 to 2162, 1996 (U.S.A.)
Non-Patent Document 3:
   Nature, 357, p. 477 to 479, 1992 (U.K.)
Non-Patent Document 4:
   Applied Physics Letters, 64, p. 1245 to 1247, 1994 (U.S.A.)
Non-Patent Document 5:
   Applied Physics Letters, 72, p. 2660 to 2662, 1998 (U.S.A.)

JP 10-308280 discloses the addition of certain amine polymers to organic compound thin layers in an electroluminescent element to improve light emission and durability.

WO 2005/092984 (EP-A-1,728,827) discloses a charge transporting varnish which is a solution or dispersion of an oligoaniline of MW 250-5000, and a polyimide or polyimide precursor of specified structure.

EP-A-1,403,325 concerns liquid crystal alignment films comprising a polyimide of specified structure. It may also contain a polyamic acid.

LIOU, Guey-Sheng et al., J. Polym. Sci. (A), 40, 3815-3822 (2002) concerns synthesis of aromatic poly (amine-imide) of the formula 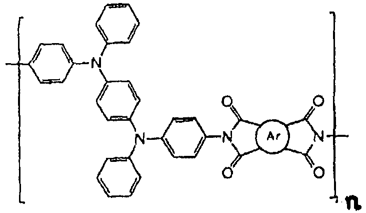 where Ar is an aromatic residue.

### DISCLOSURE OF THE INVENTION

### Problems to be Solved by the Invention

With the foregoing circumstances in view, the present invention has as objects thereof the provision of a charge-transporting varnish, which can form a thin film having no defects, high uniformity and flatness and excellent mechanical strength and heat resistance and, when used especially for organic EL devices, can realize superb EL characteristics, such as low drive voltage, high luminescence efficiency and long operating life; and also a charge-transporting thin film making use of the charge-transporting varnish.

### Means for Solving the Problems

The present inventors have proceeded with an extensive investigation to achieve the above-described objects. As a result, it has been found that use of a charge-transporting varnish, which contains at least one charge-transporting polymer with predetermined repeating units contained therein, makes it possible to form a thin film having high uniformity and flatness and excellent mechanical strength and heat resistance and further that the thin film is suited as a charge-transporting thin film for an organic EL device, leading to the completion of the present invention.

Described specifically, the present invention provides inventive subject matter as defined in the accompagning claims.

### Benefits of the Invention

The use of the charge-transporting varnish of the invention makes it possible to form charge-transporting thin films of high uniformity and flatness and excellent mechanical strength, heat resistance and transparency by various methods, such as spin coating, printing, spraying and the like.
By forming a charge-transporting thin film according to the invention on an electrode surface, the electrode surface is rendered flat and uniform so that electric short-circuiting can be prevented. The use of these thin films as a charge injection layer and a charge transport layer in an organic EL device makes it possible to realize improvements in initial characteristics and an increase in device operating life, such as lower drive voltage and higher luminescence efficiency.
The charge-transporting varnish of the invention has high self-flattening property and heat resistance and can easily form charge-transporting thin films by various coating methods, and therefore, is useful for applications in organic electronic devices such as organic field-effect devices, as capacitor-electrode protecting films, and also as antistatic films.

### BEST MODE FOR CARRYING OUT THE INVENTION

The invention will hereinafter be described in further detail.

The charge-transporting varnish of the invention is a solution or dispersion of a charge-transporting material or charge-transporting organic material and at least one charge-transporting polymer in at least one solvent, said charge-transporting material being composed of a charge-transporting oligoaniline derivative having a number average molecular weight of from 250 to 5,000, said charge-transporting organic material being composed of said charge-transporting material and a charge-accepting dopant material, wherein said charge-transporting material is an oligoaniline derivative represented by the following formula (21) or a quinonediimine derivative which is an oxidation product of the formula (21): 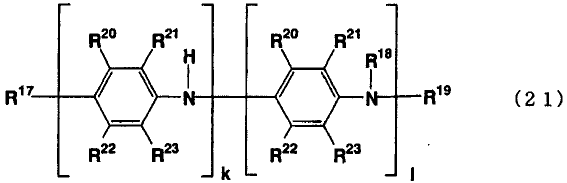 wherein R¹⁷, R¹⁸ and R¹⁹ each independently represent a hydrogen atom, a monovalent hydrocarbon group or an organoxy group, R²⁰ to R²³ each independently represent a hydrogen atom, a hydroxyl group, a monovalent hydrocarbon group, an organoxy group, an acyl group or a sulfone group, and k and 1 each independently stand for an integer not smaller than 1 and satisfy k+1 ≤ 20, and said charge-transporting polymer containing being a polyimide precursor represented by the following formula (9) or polyimide obtained by subjection said polyimide precursor to cyclodehydration: 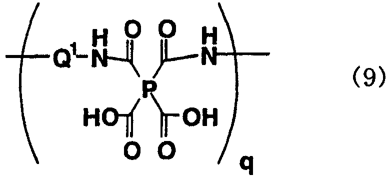 wherein P is at least one tetravalent organic group selected from the following formulas (10) to (16): 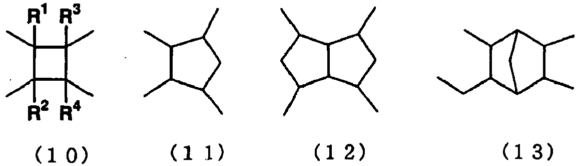 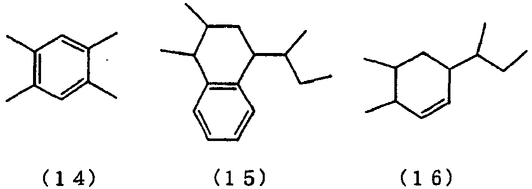 wherein in the formula (10), R¹ to R⁴ each independently represent a hydrogen atom, a fluorine atom, a C 1 to C5 alkyl group which may have a branched structure, or a C 1 to C5 alkoxy group which may have a branched structure, Q¹ is at least one divalent organic group selected from the formulas (2) to (8) 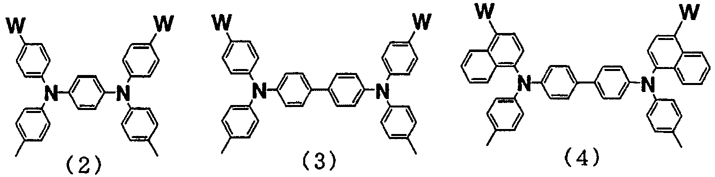 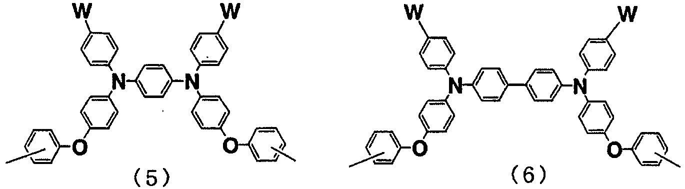 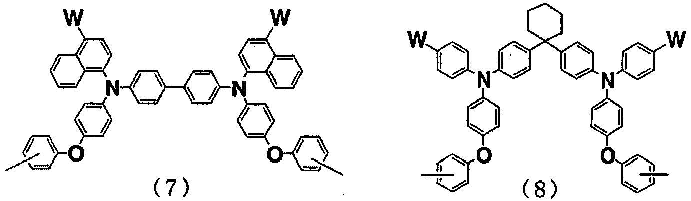 wherein W represents a hydrogen atom, a fluorine atom, a C1 to C5 alkyl group which may have a branched structure, or a C1 to C5 alkoxy group which may have a branched structure and q stands for a positive integer of not smaller than 1; provided that said polyimide precursor is not one represented by the following formula (17): 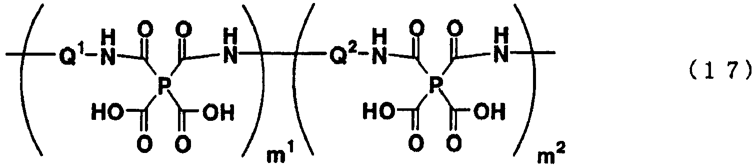 wherein P and Q¹ are as defined above and Q² is at least one divalent organic group selected from the following formula (18) to (20): 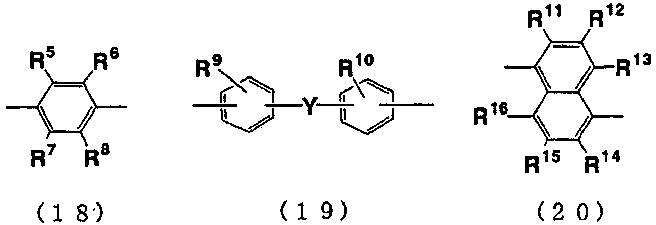 wherein R⁵ to R¹⁶ each independently represent a hydrogen atom, a fluorine atom, a C1 to C5 alkyl group which may have a branched structure, or a C1 to C5 alkoxy group which may have a branched structure, Y each independently represents a single bond, -O-, -S-, -C(O)NH-, -NHC(O)-, a C1 to C5 alkylene group which may have a branched structure, or a C1 to C5 alkylenedioxo group which may have a branched structure, and m¹ and m² each independently stand for an integer not smaller than 1, and satisfy m¹ /(m¹+ m²) ≥ 0.2.

Taking into consideration the need for improvements in the flatness and uniformity of a charge-transporting thin film to be obtained by coating the charge-transporting varnish on a substrate and baking the same, the charge-transporting polymer in the present invention may preferably be in a form dissolved in at least one solvent.

In the present invention, only one charge-transporting polymer may be used, or as an alternative, two or more polymers may be used in combination.

It is to be noted that the term "charge transportability" as used herein is synonymous with electric conductivity and means any one of hole transportability, electron transportability, and bipolar charge transportability for holes and electrons. The charge-transporting varnish of the invention can be either one having charge transportability by itself or one capable of providing a solid film, which is to be obtained by using a varnish, with charge transportability.

The charge-transporting polymer in the charge-transporting varnish of the invention is included in the charge-transporting varnish to provide a thin film, which is to be obtained by coating and baking the charge-transporting varnish, with improved mechanical strength, heat resistance and transparency and also to provide the thin film primarily with improved charge injection efficiency by charge-transporting sites represented by the formula (9) provided that said polyimide precursor is not one represented by the formula (17).
Taking into account the mechanical strength and heat resistance of a thin film to be obtained by coating and baking the charge-transporting varnish, a polyimide precursor or a polyimide obtained by subjecting the polyimide precursor to cyclodehydration is used as the charge-transporting polymer.

In a particular embodiment the charge-transporting varnish disclosed in claim 1 comprises a charge-transporting polymer wherein said P is a tetravalent organic group represented by the formula (10) and Q¹ is a divalent organic group represented by the formula (6), wherein more preferably R¹ to R⁴ and W represent a hydrogen atom.

The number average molecular weight of the charge-transporting polymer may preferably be from 1,000 to 100,000. It is to be noted that an unduly low number average molecular weight may provide the resulting thin film with insufficient strength while an excessively high number average molecular weight may leads to poor workability upon formation of a thin film. With the foregoing in view, the number average molecular weight may be more preferably from 1,000 to 50,000, with from 5,000 to 30,000 being particularly preferred.

In the use of a thin film according to the invention consideration or transparency and polymerization reactivity dictate the use, as the charge-transporting polymer in the varnish of the present invention, a polyimide precursor represented by the following formula (9) or a polyimide obtained by subjecting the polyimide precursor to cyclodehydration:

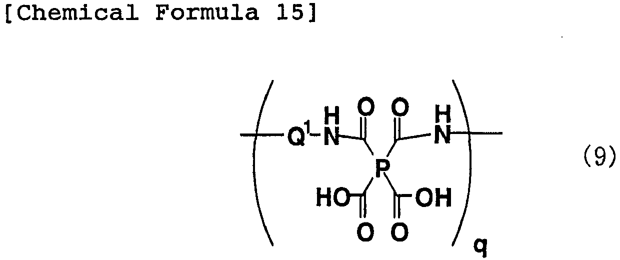

wherein P is at least one tetravalent organic group selected from the following formulas : (10) to (13),(15) and (16): 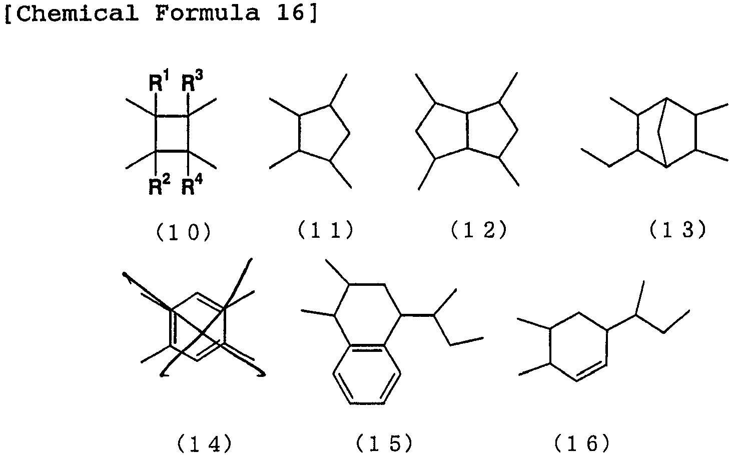 wherein in the formula (10), R¹ to R⁴ each independently represent a hydrogen atom, a fluorine atom, a C1 to C5 alkyl group which may have a branched structure, or a C1 to C5 alkoxy group which may have a branched structure, Q¹ is at least one divalent organic group selected from the formulas (2) to (8), and q stands for a positive integer of not smaller than 1, wherein the varnish does not contain a charge-transporting material composed of oligoaniline derivatives having a number average molecular weight of from 250 to 5,000.

In the use of a thin film according to the invention, considerations of transparency and polymerization reactivity also permit the use of a polyimide precursor represented by the following formula (17) or a polyimide obtained by subjecting the polyimide precursor to cyclodehydration: 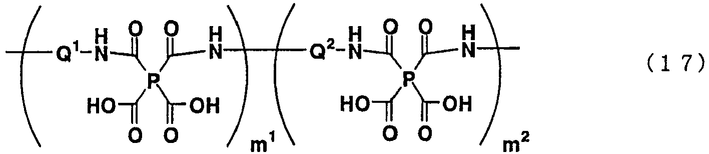 wherein P is at least one tetravalent organic group selected from the following formulas (10) to (13), (15) and (16): 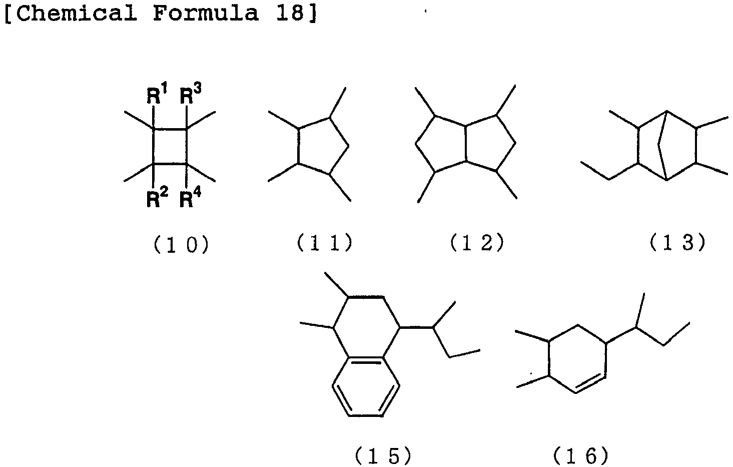 wherein in the formula (10), R¹ to R⁴ each independently represent a hydrogen atom, a fluorine atom, a C1 to C5 alkyl group which may have a branched structure, or a C1 to C5 alkoxy group which may have a branched structure, Q¹ is at least one divalent organic group selected from the formulas (2) to (8), Q² is at least one divalent organic group selected from the following formula (18) to (20): 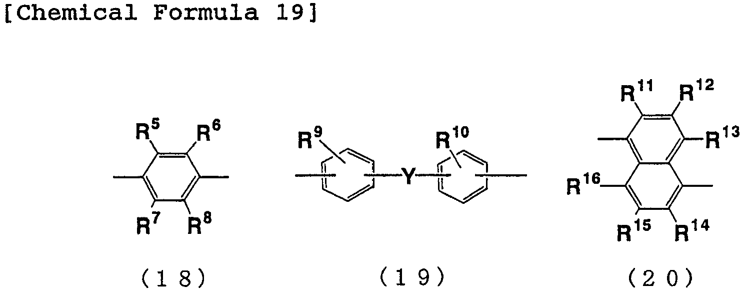 wherein R⁵ to R¹⁶ each independently represent a hydrogen atom, a fluorine atom, a C1 to C5 alkyl group which may have a branched structure, or a C1 to C5 alkoxy group which may have a branched structure, Y each independently represents a single bond, -O-, -S-, -C(O)NH-, -NHC(O)-, a C1 to C5 alkylene group which may have a branched structure, or a C1 to C5 alkylenedioxo group which may have a branched structure, and m¹ and m² each independently stand for an integer not smaller than 1, and satisfy m¹/ (m¹+m²) ≥ 0.2, and wherein the varnish does not contain a charge-transporting material composed of oligoaniline derivatives having a number average molecular weight of from 250 to 5,000.

In the above-described formula, Q¹ is a charge-transporting site, so that the polyimide precursor or polyimide is not provided with sufficient charge transportability if the percentage of Q¹ is excessively low. As the lower limit, the value of m¹/(m¹+m²) is, therefore, 0.2 in the formula (17), with 0.5 being more preferred and 0.8 being still more preferred.
As the C1 to C5 alkyl group or C1 to C5 alkoxy group represented by R⁵ to R¹⁶ and the C1 to C5 alkylene group or C1 to C5 alkylenedioxo group which may have a branched structure and is represented by Y, the same specific examples as described above can also be mentioned.

No particular limitation is imposed on the production process of the polyimide or polyimide precursor to be used in the charge-transporting varnish of the invention.
As a production process of the polyimide precursor, there can be mentioned, for example, a process that polymerizes a tetracarboxylic acid or a derivative thereof with a primary diamine. As a production process of the polyimide, on the other hand, there can be mentioned, for example, a process that subjects the polyimide precursor obtained by the above process to cyclodehydration at 100 to 400°C or a process that conducts chemical imidation of the polyimide precursor obtained by the above process while using an imidation catalyst such as triethylamine/acetic anhydride. Upon conducting the process, the polyimide precursor may partially be left unimidated to assure solubility.

As the tetracarboxylic acid derivative for use in the polymerization of the polyimide precursor, it is common to use a tetracarboxylic dianhydride.
The ratio of the total molar number of the primary diamine to that of the tetracarboxylic dianhydride may preferably be from 0.80 to 1.20. Excessive use of the primary diamine may intensify the coloration of the solution, while excessive use of the anhydride may afford an anhydride-terminated polyimide precursor and may thus lead to an unstable structure. With the foregoing in view, the above-described ratio may more preferably be from 1.05 to 1.10. Similar to general polycondensation reactions, the polymerization degree of the resulting polymer becomes higher as the above-described ratio becomes closer to 1. An unduly low polymerization degree may provide the resulting polyimide film with insufficient strength, while an excessively high polymerization degree may result in poor workability upon formation of a polyimide film. Accordingly, the polyimide or polyimide precursor for use in the invention may preferably have a number average molecular weight of from 1,000 to 50,000, with a number average molecular weight of from 5,000 to 30,000 being particularly preferred.

No particular limitation is imposed on the process that reacts and polymerizes the tetracarboxylic dianhydride and the primary diamine. It is, however, the common practice to adopt the process that the primary diamine is dissolved in an organic polar solvent such as N-methyl-2-pyrrolidone (hereinafter abbreviated as "NMP"), N,N-dimethylacetamide (hereinafter abbreviated as "DMAc") or N,N-dimethylformamide (hereinafter abbreviated as "DMF") and the tetracarboxylic dianhydride is added to the thus-prepared solution and is reacted with the primary diamine to synthesize the polyimide precursor. As the reaction temperature upon reacting the tetracarboxylic dianhydride with the primary diamine into the polyimide precursor, a desired temperature of from -20 to 150°C, preferably from -5 to 100°C can be selected.

Specific examples of the tetracarboxylic acid or its derivative usable upon obtaining the polyimide or polyimide precursor include tetracarboxylic acids such as pyromellitic acid, 1,2,3,4-cyclobutanetetracarboxylic acid, 1,2-dimethyl-1,2,3,4-cyclobutanetetracarboxylic acid, 1,3-dimethyl-1,2,3,4-cyclobutanetetracarboxylic acid, 1,2,3,4-tetramethyl-1,2,3,4-cyclobutanetetracarboxylic acid, 1,2,3,4-tetrafluoro-1,2,3,4-cyclobutanetetracarboxylic acid, 1,2,3,4-cyclopentanetetracarboxylic acid, bicyclo[3,3,0]octane-2,4,6,8-tetracarboxylic acid, 3,5,6-tricarboxybicyclo[2,2,1]hexane-2-acetic acid, 3,4-dicarboxy-1,2,3,4-tetrahydro-1-naphthalenesuccinic acid and 4,5-dicarboxy-2-cyclohexen-1-yl-succinic acid, and their dianhydrides; and their dicarboxylic acid diacid halides. These tetracarboxylic acids and their derivatives can be used either singly or in combination.

In producing the polyimide or polyimide precursor for use in the present invention, a diamine represented by the following formulae (23) to (29) can be used;

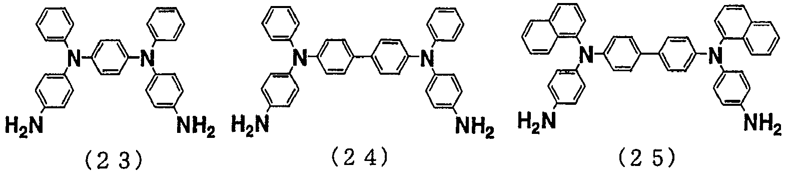

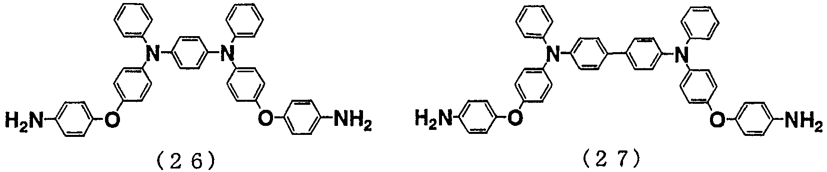

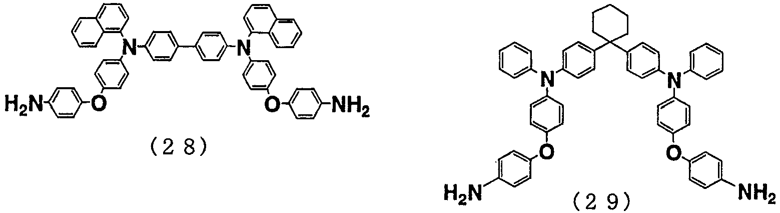

The use of the diamines represented by the formulas (23) to (29) is preferred in view of the solubility, charge transportability, ionization potential and the like of the resulting polyimide precursors or polyimides. These diamines can be used either singly or in combination.

The charge-transporting varnish of the invention also includes a solution or dispersion of a charge-transporting material or charge-transporting organic material, the charge-transporting material being composed of a charge-transporting oligoaniline derivative having a number average molecular weight of from 250 to 5,000 and the charge-transporting organic material being composed of the charge-transporting material and a charge-accepting dopant material. The charge-transporting material is further defined in claim 1. It should be soluble or dispersible in the solvent. Taking into consideration the flatness and uniformity of the resulting charge-transporting thin film, however, the charge-transporting material may preferably be in a form dissolved in the solvent.
The number average molecular weight of the oligoaniline is from 250 to 5,000. A number average molecular weight lower than 250 may lead to excessively high volatility and hence to a potential problem that charge transportability may not be fully developed. A number average molecular weight higher than 5,000, on the other hand, may lead to unduly low solubility in the solvent and hence to a potential problem that it may not be suited for use.
Especially taking into consideration that the charge-transporting material be provided with improved solubility in the solvent, its number average molecular weight may desirably be 2,000 or lower, with 800 or lower being suited.
It is to be noted that the number average molecular weight is a value as measured by gel permeation chromatography (polystyrene-converted).

Taking into consideration that the solubility in the solvent and the charge transportability be made uniform, the charge-transporting substance may preferably be an oligoaniline derivative having no molecular weight distribution, in other words, a scattering degree of 1. Also taking into consideration the solubility in the solvent and the transparency of the resulting solution, the oligoaniline derivative may preferably be one subjected to reduction treatment with hydrazine.
The oligoaniline derivative is represented by the following formula (21) or its oxidation product, i.e., a quinonediimine derivative in view of the fact that it shows high solubility and appropriate ionization potential and also the fact that the resulting charge-transporting thin film is provided with improved charge transportability when the intramolecular π conjugated system is caused to extend as much as possible.

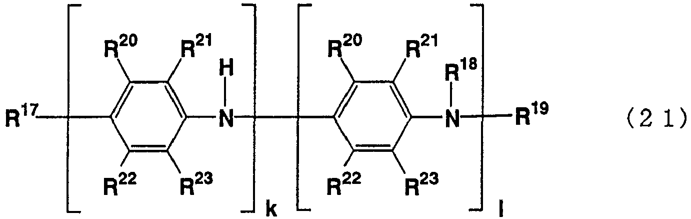

wherein R¹⁷, R¹⁸ and R¹⁹ each independently represent a hydrogen atom, a monovalent hydrocarbon group or an organoxy group, R²⁰ to R²³ each independently represent a hydrogen, a hydroxyl group, a monovalent hydrocarbon group, an organoxy group, an acyl group or a sulfone group, and k and 1 each independently stand for an integer not smaller than 1 and satisfy k+1 ≤ 20.

It is to be noted that the term "quinonediimine derivative" means a compound which has a partial structure represented by the following formula (36) in its skeleton:

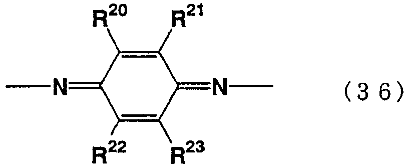

wherein R²⁰ to R²³ have the same meaning as described above.

In the formula (21), k+1 may preferably be 3 or greater from the standpoint of allowing to exhibit good charge transportability. From the standpoint of assuring solubility to the solvent, on the other hand, k+1 may be preferably 16 or smaller, more preferably 12 or smaller, most preferably 6 or smaller.
It is to be noted that only a single charge-transporting material may be used or two or more charge-transporting materials may be used in combination.

As the monovalent hydrocarbon groups, organoxy groups and acyl groups represented by R¹⁷ to R²³, the following groups can be mentioned.
Examples of the monovalent hydrocarbon groups include alkyl groups such as methyl, ethyl, propyl, butyl, t-butyl, hexyl, octyl and decyl; cycloalkyl groups such as cyclopentyl and cyclohexyl; bicycloalkyl groups such as bicyclohexyl; alkenyl groups such as vinyl, 1-propenyl, 2-propenyl, isopropenyl, 1-methyl-2-propenyl, 1, 2 or 3-butenyl and hexenyl; aryl groups such as phenyl, xylyl, tolyl, biphenyl and naphthyl; aralkyl groups such as benzyl, phenylethyl and phenylcyclohexyl; and those formed by substituting some or all of the hydrogen atoms of these monovalent hydrocarbon groups with the corresponding numbers of halogen atoms, hydroxyl groups and/or alkoxy groups.
Examples of the organoxy groups include alkoxy groups, alkenyloxy groups and aryloxy groups, and as the alkyl groups, alkenyl groups and aryl groups forming these groups, groups similar to those exemplified above can be mentioned.
Examples of the acyl groups include formyl, propionyl, butyryl, isobutyryl, valeryl, isovaleryl and benzoyl.
The numbers of carbon atoms in these monovalent hydrocarbon groups, organoxy groups and acyl groups may be generally from 1 to 20, preferably from 1 to 8, although no particular limitation is imposed thereon.

Preferred examples of R¹⁷ and R²⁰ to R²³ include a hydrogen atom; substituted or unsubstituted aryl groups such as phenyl, xylyl, tolyl, biphenyl and naphthyl; C1 to C5 alkyl groups; C1 to C5 alkoxy groups; and acyl groups such as formyl, acetyl, propionyl, butyryl, isobutyryl and benzoyl. From the standpoint of improving the solubility to organic solvents, a hydrogen atom, C1 to C5 alkyl groups and C1 to C5 alkoxy groups are particularly preferred.
As R¹⁸, from the standpoint of improving the solubility to organic solvents, a hydrogen atom, C1 to C5 alkyl group or phenyl group is preferred; from the standpoint of allowing to exhibit good charge transportability, a hydrogen atom or methyl; or a substituted or unsubstituted aryl group such as xylyl, tolyl, biphenyl or naphthyl is preferred; and from the standpoint of providing both solubility and charge transportability, a hydrogen atom, methyl group or phenyl group is particularly preferred.
As R¹⁹, from the standpoint of allowing to exhibit good charge transportability, a hydrogen atom; a substituted or unsubstituted aryl group such as phenyl, xylyl, tolyl, biphenyl or naphthyl; a C1 to C5 alkyl group; or a C1 to C5 alkoxy group is preferred, with an aryl group such as phenyl, xylyl, biphenyl or naphthyl being particularly preferred.
Among these, it is preferred that R¹⁷ is a hydrogen atom and R¹⁹ is a phenyl group, in other words, both ends of the oligoaniline compound of the formula (21) are capped with phenyl groups.
Specific examples of such compounds include oligoaniline derivatives soluble in organic solvents, such as phenyltetraaniline, phenylpentaaniline, tetraaniline (aniline tetramer) and octaaniline (aniline octamer).

Usable examples of a process for the synthesis of these oligoaniline derivatives include, but are not limited to, the processes described in Bulletin of Chemical Society of Japan, 67, p. 1749 to 1752, 1994 and Synthetic Metals, 84, p. 119 to 120, 1997 (U.S.A.).

In the charge-transporting varnish of the invention, a charge-transporting organic material composed of the above-mentioned charge-transporting material and a charge-accepting dopant material can be used in addition to the embodiment that uses the charge-transporting material. No particular limitation is imposed either on this charge-transporting organic material insofar as it is soluble or dispersible in a solvent. However, one soluble in a solvent is preferred when the flatness and uniformity of the resulting charge-transporting thin film is taken into consideration. No particular limitation is imposed on the solubility of the charge-accepting dopant material insofar as it is soluble in at least one solvent usable in the varnish.
The charge-accepting dopant material is added to improve the charge transportability of the charge-transporting material. An electron-accepting dopant material can be used for a hole-transporting material, while a hole-accepting dopant material can be used for an electron-transporting material. These electron-accepting dopant material and hole-accepting dopant material are both desired to be materials having high charge acceptability.

As a charge-transporting oligoaniline in a charge-transporting varnish generally shows hole transportability, it is preferred to use an electron-accepting dopant material as a charge-accepting dopant material in the invention.
Specific examples of the electron-accepting dopant material include, but are not limited to, strong inorganic acids such as hydrogen chloride, sulfuric acid, nitric acid and phosphoric acid; Lewis acids such as aluminum(III) chloride (AlCl₃), titanium(IV) tetrachloride (TiCl₄), boron tribromide (BHr₃), boron tribromide-ethyl ether complex (BF₃·OEt₂), iron(III) chloride (FeCl₃), copper(II) chloride (CuCl₂), antimony(V) pentachloride (SbCl₅), arsenic(V) pentafluoride (AsF₅), phosphorus pentafluoride (PF₅) and tris(4-bromophenyl)aluminum hexachloroantimonate (TBPAH); strong organic acids such as benzenesulfonic acid, tosic acid, camphorsulfonic acid, hydroxybenzenesulfonic acid, 5-sulfosalicylic acid, dodecylbenzenesulfonic acid and polystyrenesulfonic acid; and organic or inorganic oxidizing agents such as 7,7,8,8-tetracyanoquinodimethane (TCNQ), 2,3-dichloro-5,6-dicyano-1,4-benzoquinone (DDQ) and iodine.
Specific examples of the hole-accepting dopant include, but are not limited to, alkali metals (Li, Na, K, Cs), and metal complexes such as lithium quinolate (Liq) and lithium acetyl acetonate (Li(acac)).
These electron-accepting dopant materials can be used either singly or in combination.

Preferably, the charge-transporting material and charge-accepting dopant material are both amorphous solids in the present invention. When there is a need to use a crystalline solid as at least one of these materials, it is preferred to use a material which gives rise to an amorphous solid after use of a varnish - which includes the charge-transporting material, the charge-accepting dopant material and a solvent, which contains a high-viscosity to form solvent to be described in detail subsequently herein - to form a film.
Especially when at least one of the charge-transporting material and charge-accepting dopant material is a crystalline solid, this at least one material may preferably be a material having random intermolecular interaction. When a low molecular compound is used as the charge-accepting dopant, the low molecular compound may preferably be a compound which contains three or more different kinds of polar functional groups within the same molecule.
No particular limitation is imposed on such a compound, and illustrative are Tiron, dihydroxybenzenesulfonic acid, and sulfonic acid derivatives represented by formula (37), with the sulfonic acid derivatives represented by the formula (37) being preferred. Specific examples of the sulfonic acid derivatives include sulfosalicylic acid derivatives, for example, 5-sulfosalicylic acid.

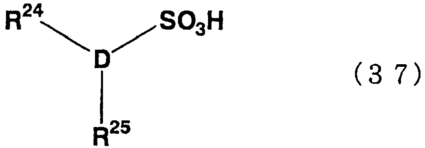

wherein D represents a benzene ring, naphthalene ring, anthracene ring, phenanthrene ring or heterocycle, and R²⁴ and R²⁵ each independently represent a carboxyl group or hydroxyl group.

If the content of the charge-transporting polymer in the charge-transporting varnish of the invention, the varnish containing the charge-transporting material or charge-transporting organic material and the charge-transporting polymer, is low, its effects cannot be brought about sufficiently. If the content of the charge-transporting polymer is excessively high, on the other hand, the resulting charge-transporting thin film is provided with reduced charge transportability. Accordingly, as its content, the lower limit may be 0.1 wt%, more preferably 1.0 wt%, still more preferably 5 wt% and the upper limit may be preferably 50 wt%, more preferably 30 wt%, still more preferably 20 wt%.

Solvents useful for obtaining the charge-transporting varnish of the invention include, but are not limited to, water, methanol, DMF, DMAc, NMP, N,N'-dimethylimidazolidinone, dimethylsulfoxide, chloroform and toluene. They can be used either singly or in combination.
To an extent not impairing the solubility, a high-viscosity solvent may be mixed to obtain a high-viscosity varnish. Examples of the high-viscosity solvent include, but are not limited to, cyclohexanol, ethylene glycol, ethylene glycol glycidyl ether, 1,3-octylene glycol, diethylene glycol, dipropylene glycol, triethylene glycol, tripropylene glycol, 1,3-butanediol, 1,4-butanediol, propylene glycol, and hexylene glycol. Of these, it is particularly preferred to use cyclohexanol or dipropylene glycol from the standpoint that it has an adequate viscosity and boiling point and shows good applicability to substrates.
To an extent not impairing the solubility, a solvent which imparts flatness to a film upon baking may also be used in the varnish of the invention to improve its wetting properties to substrates and to adjust the surface tension, polarity and boiling point of the solvent. Specific examples of such a solvent include, but are not limited to, butylcellosolve, diethylene glycol diethyl ether, dipropylene glycol monomethyl ether, ethyl carbitol, diacetone alcohol, γ-butyrolactone, and ethyl lactate.

The charge-transporting thin film prepared by means of the invention is prepared by using the above-mentioned charge-transporting varnish, and this charge-transporting thin film can be suitably used as a hole injection layer or hole transport layer or an election injection layer or electron transport layer in an organic EL device.
This thin film can be formed, for example, by coating the charge-transporting varnish on a substrate and evaporating the solvent. Although no particular limitation is imposed on the coating method of the varnish, dipping, spin coating, transfer printing, roll coating, inkjet, spraying, brush coating and the like can be mentioned. These coating methods can all form uniform films.
No particular limitation is imposed on the method for the evaporation of the solvent. A uniform film surface can be obtained by performing the evaporation on a hot plate or in an oven under an appropriate atmosphere, specifically, air or an inert gas such as nitrogen or in a vacuum. No particular limitation is imposed on the baking temperature insofar as the evaporation of the solvent is feasible. Preferably, however, the baking may be performed at from 40 to 250°C. To develop still higher uniform film-forming properties or to allow a reaction to proceed on the substrate, the temperature may be changed at two or more levels.

No particular limitation is imposed on the thickness of the charge-transporting film. When employed as a charge injection layer in an organic EL device, however, a thickness of from 5 to 200 nm is preferred. As a method for varying the film thickness, there is a method such as changing the concentration of solids in the varnish or changing the coat weight on the substrate upon coating the same.
For the fabrication of an OLED device by use of the charge-transporting varnish (charge-transporting thin films) of the invention, the following procedure and materials can be mentioned although the fabrication procedure and materials are not limited to them.
An electrode substrate to be used is cleaned beforehand by subjecting it to liquid cleaning, e.g. with a detergent, an alcohol or pure water. In the case of an anode substrate, it is preferred to conduct surface treatment such as ozone treatment or oxygen-ozone treatment immediately before its use. Such surface treatment may, however, be omitted when the anode material contains an organic material as a main component.

When a hole-transporting varnish is used for an OLED device, a thin film may be formed and used by the procedure to be described hereinafter.
Using the hole-transporting varnish for an anode substrate, a hole-transporting thin film is formed on an electrode by the above-described coating method. The substrate with the thin film formed thereon is introduced into a vacuum evaporation system, and a hole transport layer, a luminescent layer, an electron transport layer, an electron injection layer and a cathode metal are successively deposited to fabricate the OLED device. Upon fabrication, a carrier blocking layer may be arranged between desired layers to control an emitting region.
As the anode material, a transparent electrode represented by indium tin oxide (ITO) or indium zinc oxide (IZO) can be mentioned, with one subjected to leveling treatment being preferred. Polythiophene derivatives and polyanilines, which have high charge transportability, can also be employed.

As materials usable for the formation of the hole transport layer, there can be mentioned triarylamines such as (triphenylamine)dimer derivatives (TPD), (α-naphthyldiphenylamine)dimer (α-NPD) and [(triphenylamine) dimer]spirodimer (Spiro-TAD); starburst amines such as 4,4',4"-tris[3-methylphenyl(phenyl)amino]triphenylamine (m-MTDATA), 4,4',4"-tris[1-naphthyl(phenyl)amino]triphenylamine (1-TNATA); and oligothiophenes such as 5,5"-bis-{:4-[bis(4-methylphenyl)amino]phenyl}-2,2':5',2"-terthiophene (BMA-3T).
As materials usable for the formation of the emitting layer, there can be mentioned tris(8-quinolinolate)aluminum(III)(Alq₃), bis(8-quinolinolate)zinc(II)(Znq₂), bis(2-methyl-8-quinolinolate)(p-phenylphenolate)aluminum-(III)(BAlq), and 4,4'-bis(2,2-diphenylvinyl)biphenyl(DPVBi). The emitting layer may also be formed by subjecting an electron-transporting material or hole-transporting material and a luminescent dopant to coevaporation.

As the electron-transporting material, Alq₃, BAlq, DPVBi, (2-(4-biphenyl)-5-(4-t-butylphenyl)-1,3,4-oxadlazole)(PBD), a triazole derivative (TAZ), bathocuproin (BCP) and a silole derivative can be mentioned.
As the emitting dopant, quinacridone, rubrene, coumarin 540, 4-(dicyanomethylene)-2-methyl-6-(p-dimethylaminostyryl)-4H-pyran (DCM), tris(2-phenylpyridine)-indium(III)(Ir(ppy)₃) and (1,10-phenanthroline)-tris(4,4,4-trifluoro-1-(2-thienyl)-butane-1,3-dionato)europium(III) (Eu(TTA)₃phen) can be mentioned.
As a material for forming the carrier blocking layer, PBD, TAZ or BCP can be mentioned.

As a material for forming the electron injection layer, lithium oxide (Li₂O), magnesium oxide (MgO), alumina (Al₂O₃), lithium fluoride (LiF), magnesium fluoride (MgF₂) strontium fluoride (SrF₂), Liq, Li(acac), lithium acetate and lithium benzoate can be mentioned.
As a cathode material, aluminum, magnesium-silver alloy, aluminum-lithium alloy, lithium, sodium, potassium and cesium can be mentioned.

When an electron-transporting varnish is used for an OLED device, a thin film may be formed and used by the procedure to be described hereinafter.
Using the electron-transporting varnish, an electron-transporting thin film is formed on a cathode substrate. The substrate with the thin film formed thereon is introduced into a vacuum evaporation system. After an electron transport layer, a luminescent layer, a hole transport layer and a hole injection layer are formed with similar materials as described above, the cathode material is formed into a film by a method such as sputtering to fabricate the OLED device.

Although no particular limitation is imposed on the procedure for the fabrication of the PLED device by the use of the charge-transporting varnish of the invention, the following procedure can be mentioned.
By forming a luminescent, charge-transporting polymer layer in place of conducting the vacuum evaporation operations of the hole transport layer, luminescent layer, electron transport layer and electron injection layer in the fabrication of the OLED device, the PLED device can be fabricated with a charge-transporting thin film formed with the charge-transporting varnish of the invention.
Described specifically, using a hole-transporting varnish for an anode substrate, a hole-transporting thin film is formed on an electrode by a similar method as in the fabrication of the OLED device, a luminescent, charge-transporting polymer layer is formed over the hole-transporting thin film, and further, a cathode is deposited to fabricate the PLED device.
As an alternative, using an electron-transporting varnish for a cathode substrate, an electron-transporting thin film is formed on an electrode by a similar method as in the fabrication of the OLED device, a luminescent, charge-transporting polymer layer is formed over the electron-transporting thin film, and further, an anode is deposited by a method such as sputtering, vacuum evaporation or spin coating to fabricate the PLED device.

As the cathode and anode materials to be used, similar materials as in the fabrication of the OLED device can be used, and similar cleaning treatment and surface treatment can be conducted.
As a method for the formation of the luminescent, charge-transporting polymer layer, there can be mentioned the method that a solvent is added to a luminescent, charge-transporting polymer material or a material composed of the polymer material and a luminescent dopant added thereto to dissolve or uniformly disperse the polymer material or the material, the solution or dispersion is coated on an electrode substrate with a hole injection layer formed thereon, and then, the solvent is evaporated to form a film.
As the luminescent, charge-transporting polymer material, a polyfluorene derivative such as a poly(9,9-dialkylfluorene)(PDAF), a polyphenylenevinylene derivative such as poly(2-methoxy-5-(2'-ethylhexoxy)-1,4-phenylenevinylene (MEH-PPV), a polythiophene derivative such as a poly(3-alkylthiophene)(PAT) or polyvinylcarbazole (PVCz) can be mentioned.

As the solvent, toluene, xylene and chloroform can be mentioned. As dissolution or uniform dispersion method, a method such as stirring, heated stirring or ultrasonic dispersion can be mentioned.
Although no particular limitation is imposed on the coating method, dipping, spin coating, transfer printing, roll coating, inkjet, spraying and brush coating can be mentioned. It is desired to perform the coating under an inert gas such as nitrogen or argon.
As an evaporation method for the solvent, there can be mentioned the method that conducts heating with an oven or hot plate under an inert gas or in a vacuum.

### EXAMPLES

The present invention will hereinafter be more specifically described based on Synthesis Examples, Examples and Comparative Examples. It is, however, to be noted that the present invention shall not be limited to the following Examples.
In the following Examples and Comparative Examples, the molecular weight of each polymer was measured by using a GPC system ("SSC-7200", manufactured by Senshu Scientific Co., Ltd.) equipped with GPC columns ("KD-803"/"KD-805", manufactured by Shodex). Each film thickness was measured by using a surface profiler ("DEKTAK3ST", manufactured by Japan Vacuum Technology Co., Ltd.). Device characteristics of each OLED device, such as its brightness, current density and efficiency, were measured by using an OELD luminescence efficiency measurement system ("EL-1003", Precise Gauges Co., Ltd.).

### Synthesis Example 1

### Synthesis of Oligoaniline

Based on the procedure descried in Bulletin of Chemical Society of Japan, 67, p. 1749 to 1752, 1994, phenyltetraaniline (PTA) was obtained as will be described hereinafter.

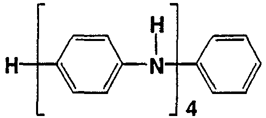

p-phenylenediamine (12.977 g) was dissolved in toluene (2 liters), and in the resultant solution, tetra-n-butoxy titanium (245.05 g) was added and dissolved at 70°C for 30 minutes. To the thus-prepared solution, p-hydroxydiphenylamine (53.346 g) was then added, followed by a reaction under a nitrogen atmosphere at a reaction temperature of 100°C for 24 hours. Subsequent to the completion of the reaction, the reaction mixture was filtered, the filter cake was successively washed with toluene and ethyl ether and then dried to obtain silvery crystals. To the thus-obtained crystals, dioxane (25 parts) and hydrazine monohydrate (0.2 equivalent) were added. After the interior of the reaction system was purged with nitrogen, the reaction mixture was heated under reflux to dissolve the crystals. To the resulting solution, toluene (25 parts relative to the crystals) was added to convert the solution into a suspension. After heating under reflux, dioxane (10 parts) was added further, and the resulting mixture was heated under reflux to dissolve the crystals. The thus-obtained solution was subjected to hot filtration. A solid precipitated from the filtrate was recrystallized, was successively washed with toluene-dioxane(1:1) and ethyl ether under a nitrogen atmosphere, and was then collected by filtration. The thus-collected crystals were dried under reduced pressure at 60°C for 10 hours. Similar recrystallization operations were repeated once again to afford white crystals (39.60 g, yield: 75%).

### Synthesis Example 2

### Polymerization of Polyamic Acid (PI-x1)

Under a nitrogen gas stream, N,N'-diphenyl-N,N'-di-(4-aminophenoxy)phenyl)benzidine (hereinafter abbreviated as "TPD-DA") (3.51 g, 5.0 mmol) was placed in a 100 mL four necked flask, and subsequent to its dissolution in NMP (10.0 g), a suspension of 1,2,3,4-cyclobutanetetracarboxylic anhydride (hereinafter abbreviated as "CBDA"; 0.91 g, 4.6 mmol) in NMP (15.1 g) was added. The resulting mixture was stirred at 23°C for 6 hours to conduct a polymerization reaction, whereby a 15% NMP solution of a polyamic acid (PI-x1) as a polyimide precursor was obtained. The number average molecular weight (Mn) and weight average molecular weight (Mw) of the thus-obtained polyamic acid (PI-x1) were Mn = 17,300 and Mw = 35,800, respectively.

### Synthesis Example 3

### Polymerization of Polyamic Acid (PI-x2)

Under a nitrogen gas stream, TPD-DA (1.69 g, 2.4 mmol) and p-phenylenediamine (1.03 g, 9.6 mmol) were placed in a 100 mL four necked flask, and subsequent to their dissolution in NMP (12.0 g), a suspension of CBDA (2.26 g, 11.5 mmol) in NMP (32.8 g) was added. The resulting mixture was stirred at 23°C for 6 hours to conduct a polymerization reaction, whereby a 10% NMP solution of a polyamic acid (PI-x2) as a polyimide precursor was obtained. The number average molecular weight (Mn) and weight average molecular weight (Mw) of the thus-obtained polyamic acid (PI-x2) were 53,000 and Mw = 122,000, respectively.

It is to be noted that TPD-DA used in the above-described Synthesis Examples 2 and 3 and represented by the following formula was synthesized following the procedure described in the pamphlet of PCT International Publication No. WO 02/100949.

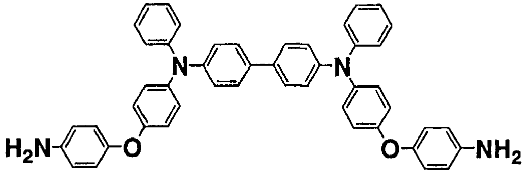

### Synthesis Example 4

### Synthesis of Polyamic Acid (PI-B)

Under a nitrogen gas stream, 4,4'-diaminodiphenyl ether (hereinafter abbreviated as "DDE") (8.01 g, 0.040 mol) was placed in a 200 mL four necked flask, and subsequent to its dissolution in NMP (87.6 g), CBDA (7.45 g, 0.038 mol) was added. The resulting mixture was stirred at 23°C for 5 hours to conduct a polymerization reaction, whereby a 15% NMP solution of a polyamic acid (PI-B) was obtained. The number average molecular weight (Mn) and weight average molecular weight (Mw) of the thus-obtained polyamic acid (PI-B) were Mn = 14,000 and Mw = 32,600, respectively.

### Example 1

To the PTA obtained in Synthesis Example 1, 5-sulfosalicylic acid was added in an amount of 8 molar equivalents relative to the PTA, and to the resulting mixture, N,N-dimethylacetamide (DMAc) was added under a nitrogen atmosphere to dissolve the PTA and DMAc. To aliquots of the resultant solution, a 15% NMP solution of the polyamic acid (PI-x1) obtained in Synthesis Example 2 was added such that the total solid contents of the polyamic acid became 10 wt%, 20 wt% and 30 wt%, respectively. Further, cyclohexanol was added, followed by stirring to prepare varnishes (X1, X2, X3) of 4% solid concentration, respectively.

Formation of thin films on ITO-coated glass substrates with the thus-obtained varnishes was conducted by a procedure to be described hereinafter. Described specifically, ozone cleaning was applied to the ITO-coated glass substrates for 40 minutes until shortly before conducting spin coating of the vanishes. The above-obtained respective varnishes (X1, X2, X3) were coated by spin-coating onto the ITO-coated glass substrates, and the thus-coated, ITO-coated glass substrates were baked in air at 200°C for 1 hour to form uniform thin films of 30 nm.

### Comparative Example 1

To the PTA obtained in Synthesis Example 1, 5-sulfosalicylic acid was added in an amount of 8 molar equivalents relative to the PTA, and to the resulting mixture, N,N-dimethylacetamide (DMAc) was added under a nitrogen atmosphere to dissolve the PTA and DMAc. To the resultant solution, a 15% NMP solution of the polyamic acid (PI-B) obtained in Synthesis Example 4 was added such that the total solid content of the polyamic acid became 10 wt%. Further, cyclohexanol was added, followed by stirring to prepare a varnish (B) of 5% solid concentration. The thus-obtained varnish (B) was coated onto an ITO-coated substrate by the procedure described in Example 1, and the thus-coated, ITO-coated glass substrate was baked in air at 200°C for 1 hour to form a uniform thin film of 30 nm.

### Comparative Example 2

To the PTA obtained in Synthesis Example 1, 5-sulfosalicylic acid was added in an amount of 8 molar equivalents relative to the PTA, and to the resulting mixture, N,N-dimethylacetamide (DMAc) was added under a nitrogen atmosphere to dissolve the PTA and DMAc. To the resultant solution, cyclohexanol was added, followed by stirring to prepare a varnish (C) of 5% solid concentration. The thus-obtained varnish (C) was coated onto an ITO-coated substrate by the procedure described in Example 1, and the thus-coated, ITO-coated glass substrate was baked in air at 200°C for 1 hour to form a uniform thin film of 30 nm.

### Example 2

After the varnish (X1) obtained in Example 1 was formed into a hole-transporting thin film on an ITO-coated glass substrate by the procedure described in Example 1, the ITO-coated glass substrate with the thin film formed thereon was introduced into a vacuum evaporation system, and then, α-NPD, Alq₃, LiF and Al were successively deposited to fabricate an OLED device. Their film thicknesses were controlled to 40 nm, 45 nm, 0.5 nm and 100 nm, respectively. Their evaporation operations were each initiated after the pressure was reduced to 8×10⁻⁴ Pa or lower. The deposition rate was set at from 0.3 to 0.4 nm/s except for LiF, and with respect to LiF, the deposition rate was set at from 0.02 to 0.04 nm/s. Transfer operations between the respective evaporation operations were performed in a vacuum. Characteristics of the resultant OLED device are presented in Table 1.

### Comparative Example 3

After the varnish (B) obtained in Comparative Example 1 was formed into a hole-transporting thin film on an ITO-coated glass substrate by the procedure described in Example 1, vacuum evaporation was conducted in the manner described in Example 2 to fabricate an OLED device. Characteristics of the resultant OLED device are presented in Table 1.

### Comparative Example 4

After the varnish (C) obtained in Comparative Example 2 was formed into a hole-transporting thin film on an ITO-coated glass substrate by the procedure described in Example 1, vacuum evaporation was conducted in the manner described in Example 2 to fabricate an OLED device. Characteristics of the resultant OLED device are presented in Table 1.

**Table 1**

| | Varnish | Kind of polyimide | Percentage of polyimide (wt%) | Light-emission initiating voltage (V) | Upon application of a current at 50 mA/cm² | | |
|---|---|---|---|---|---|---|---|
| | | | | | Voltage (V) | Brightness (cd/m²) | Current efficiency (1 m/W) |
| Example 2 | X1 | PI-x1 | 10 | 2.8 | 7.5 | 1720 | 1.4 |
| Comparative Example 3 | B | PI-B | 10 | 3.0 | 8.5 | 1710 | 1.3 |
| Comparative Example 4 | C | None | 0 | 3.0 | 8.9 | 1380 | 1.0 |

As presented in Table 1, it is appreciated that the OLED device of Example 2 equipped with the film formed from the varnish (X1) making use of the polyamic acid showed as its characteristics a lower light-emitting initiating voltage, lower drive voltage and higher efficiency compared with the device of Comparative Example 4 equipped with the film formed from the varnish (C) containing no polyamic acid. Further, it is appreciated that the OLED device of Example 2 also showed a lower light-emitting initiating voltage and drive voltage compared the device of Comparative Example 3 equipped with the film formed from the varnish (B) containing the polyamic acid which did not contain the structure represented by the formula (1).

### Example 3

After the respective varnishes (X1, X2, X3) obtained in Example 1 were formed into hole-transporting thin films on ITO-coated glass substrates by the procedure described in Example 1, the ITO-coated glass substrates with the thin films formed thereon were introduced into a vacuum evaporation system, and then, α-NPD, Alq₃, LiF and Al were successively deposited to fabricate OLED devices. Their film thicknesses were controlled to 30 nm, 40 nm, 0.5 nm and 100 nm, respectively. Their evaporation operations were each initiated after the pressure was reduced to 8×10⁻⁴ Pa or lower. The deposition rate was set at from 0.3 to 0.4 nm/s except for LiF, and with respect to LiF, the deposition rate was set at from 0.02 to 0.04 nm/s. Transfer operations between the respective evaporation operations were performed in a vacuum. Characteristics of the resultant OLED devices are presented in Table 2.

### Comparative Example 5

After the varnish (C) obtained in Comparative Example 2 was formed into a hole-transporting thin film on an ITO-coated glass substrate by the procedure described in Example 1, vacuum evaporation was conducted in the manner described in Example 3 to fabricate an OLED device. Characteristics of the resultant OLED device are presented in Table 2.

**Table 2**

| | Varnish | Kind of polyimide | Percentage of polyimide (wt%) | Light-emission initiating voltage (V) | Upon application of a current at 50 mA/cm² | | |
|---|---|---|---|---|---|---|---|
| | | | | | Voltage (V) | Brightness (cd/m²) | Current efficiency (1 m/W) |
| Example 3 | X1 | PI-x1 | 10 | 2.8 | 6.3 | 1680 | 1.7 |
| | X2 | PI-x1 | 20 | 2.8 | 6.8 | 1790 | 1.7 |
| | X3 | PI-x1 | 30 | 2.8 | 7.3 | 1840 | 1.6 |
| Comparative Example 5 | C | None | 0 | 2.8 | 7.7 | 2150 | 1.7 |

As presented in Table 2, it is appreciated that the respective OLED devices of Example 3 equipped with the films formed from the varnishes (X1, X2, X3) of Example 1 showed as their characteristics a lower drive voltage compared with the device of Comparative Example 5 equipped with the film formed from the varnish (C).

### Example 4

To a 15% NMP solution of the polyamic acid (PI-x2) obtained in Synthesis Example 3, NMP and butylcellosolve (NMP/butylcellosolve = 80/20 (weight ratio)) were added to prepare a varnish (X4) of 2% solid concentration. The thus-obtained varnish (X4) was coated onto an ITO-coated substrate by the procedure described in Example 1, and the thus-coated, ITO-coated glass substrate was baked in air at 200°C for 1 hour to form a uniform thin film of 30 nm.

### Example 5

After the varnish (X4) obtained in Example 4 was formed into a hole-transporting thin film on an ITO-coated glass substrate by the procedure described in Example 1, the ITO-coated glass substrate with the thin film formed thereon was introduced into a vacuum evaporation system, and then, α-NPD, Alq₃, LiF and Al were successively deposited to fabricate an OLED device. Their film thicknesses were controlled to 35 nm, 50 nm, 0.5 nm and 100 nm, respectively. Their evaporation operations were each initiated after the pressure was reduced to 8×10⁻⁴ Pa or lower. The deposition rate was set at from 0.3 to 0.4 nm/s except for LiF, and with respect to LiF, the deposition rate was set at from 0.02 to 0.04 nm/s. Transfer operations between the respective evaporation operations were performed in a vacuum. Characteristics of the resultant OLED device are presented in Table 3.

### Comparative Example 6

After the varnish (C) obtained in Comparative Example 2 was formed into a hole-transporting thin film on an ITO-coated glass substrate by the procedure described in Example 1, vacuum evaporation was conducted in the manner described in Example 5 to fabricate an OLED device. Characteristics of the resultant OLED device are presented in Table 3.

**Table 3**

| | Varnish | Kind of polyimide | Percentage of polyimide (wt%) | Light-emission initiating voltage (V) | Upon application of a current at 50 mA/cm² | | |
|---|---|---|---|---|---|---|---|
| | | | | | Voltage (V) | Brightness (cd/m²) | Current efficiency (1 m/W) |
| Example 5 | X4 | PI-x2 | 100 | 2.8 | 9.7 | 2540 | 1.7 |
| Comparative Example 6 | C | None | 0 | 3.0 | 9.3 | 2530 | 1.7 |

As presented in Table 3, it is appreciated that the OLED device of Example 5 equipped with the film formed from the varnish (X4) of Example 4 showed as its characteristic a lower light-emission initiating voltage compared with the device of Comparative Example 6 equipped with the film formed from the varnish (C) of Comparative Example 2.

## Claims

1. A charge-transporting varnish comprising a solution or dispersion of a charge-transporting material or charge-transporting organic material and at least one charge-transporting polymer in at least one solvent, said charge-transporting material being composed of a charge-transporting oligoaniline derivative having a number average molecular weight of from 250 to 5,000, said charge-transporting organic material being composed of said charge-transporting material and a charge-accepting dopant material,
wherein said charge-transporting material is an oligoaniline derivative represented by the following formula (21) or a quinonediimine derivative which is an oxidation product of the formula (21): 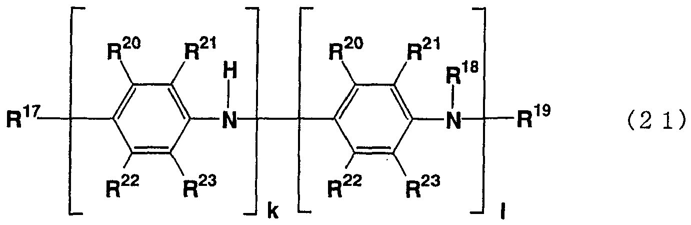 wherein R¹⁷, R¹⁸ and R¹⁹ each independently represent a hydrogen atom, a monovalent hydrocarbon group or an organoxy group, R²⁰ to R²³ each independently represent a hydrogen atom, a hydroxyl group, a monovalent hydrocarbon group, an organoxy group, an acyl group or a sulfone group, and k and 1 each independently stand for an integer not smaller than 1 and satisfy k+1 ≤ 20,
and said charge-transporting polymer being a polyimide precursor represented by the following formula (9) or polyimide obtained by subjecting said polyimide precursor to cyclodehydration: 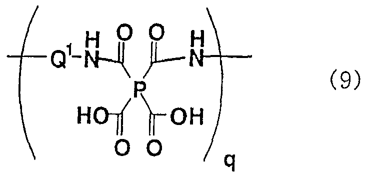 wherein P is at least one tetravalent organic group selected from the following formulas (10) to (16): 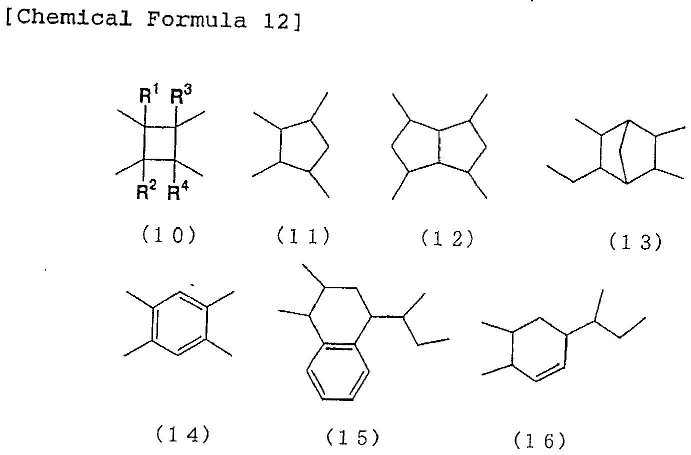 wherein in the formula (10), R¹ to R⁴ each independently represent a hydrogen atom, a fluorine atom, a C1 to C5 alkyl group which may have a branched structure, or a C1 to C5 alkoxy group which may have a branched structure,
Q¹ is at least one divalent organic group selected from the formulas (2) to (8) 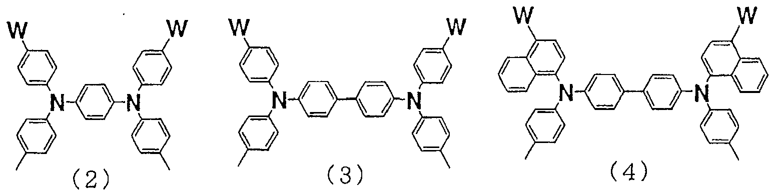 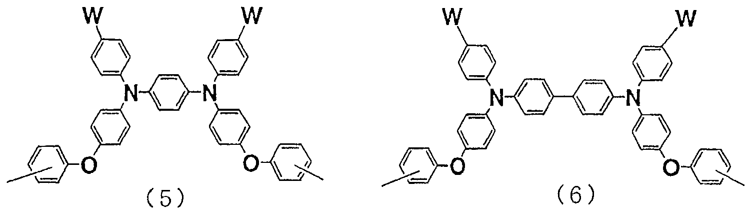 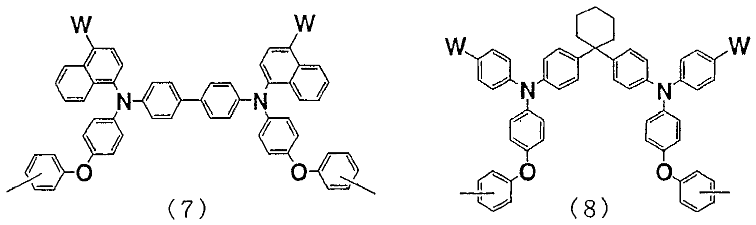 wherein W represents a hydrogen atom, a fluorine atom, a C1 to C5 alkyl group which may have a branched structure, or a C1 to C5 alkoxy group which may have a branched structure,
and q stands for a positive integer of not smaller than 1; provided that said polyimide precursor is not one represented by the following formula (17): 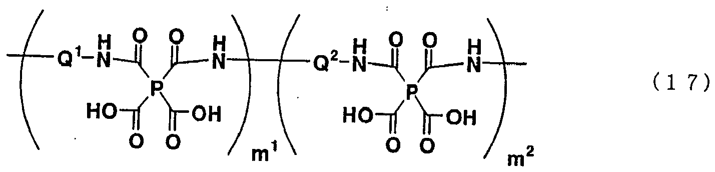 wherein P and Q¹ are as defined above, and Q² is at least one divalent organic group selected from the following formulae (18) to (20) : 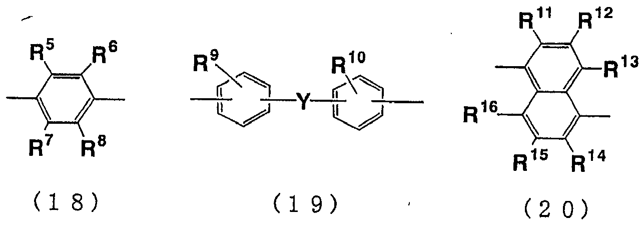 wherein R⁵ to R¹⁶ each independently represent a hydrogen atom, a fluorine atom, a C1 to C5 alkyl group which may have a branched structure, or a C1 to C5 alkoxy group which may have a branched structure, Y each independently represents a single bond, -O-, -S-, -C(O)NH-, -NHC(O)-, a C1 to C5 alkylene group which may have a branched structure, or a C1 to C5 alkylenedioxo group which may have a branched structure, and
m¹ and m² each independently stand for an integer not smaller than 1, and satisfy m¹/(m¹+m²) ≥ 0.2.

2. The charge-transporting varnish according to claim 1, wherein said P is a tetravalent organic group represented by the formula (10) and Q¹ is a divalent organic group represented by the formula (6).

3. The charge-transporting varnish according to claim 2, wherein said R¹ to R¹ and W represent a hydrogen atom.

4. The charge-transporting varnish according to any preceding claim, wherein said polyimide precursor has a number average molecular weight of from 1,000 to 100,000.

5. A charge-transporting thin film prepared by using a charge-transporting varnish according to any one of claims 1 to 4.

6. An organic electroluminescence device having at least one layer formed of a charge-transporting thin film according to claim 5.

7. Use of a varnish comprising a solution or dispersion of a charge-transporting polymer for preparing a charge-transporting thin film, said charge-transporting polymer comprising a polyimide precursor represented by the following formula (9) or (17), or a polyimide obtained by subjecting said polyimide precursor to cyclodehydration: 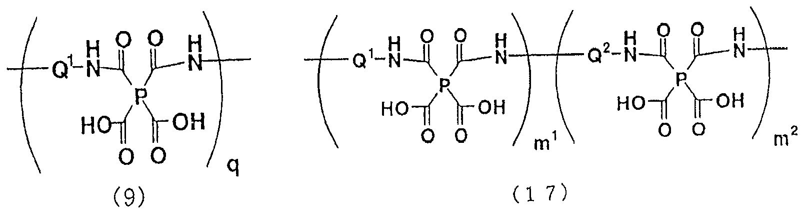 wherein P is at least one tetravalent organic group selected from the following formulas (10) to (13), (15) and (6): 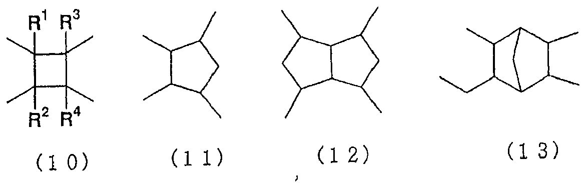 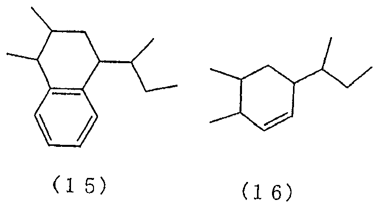 wherein in the formula (10), R¹ to R⁴ each independently represent a hydrogen atom, a fluorine atom, a C1 to C5 alkyl group which may have a branched structure, or a C1 to C5 alkoxy group which may have a branched structure,
Q¹ is at least one divalent organic group selected from the following formulas (2) to (8): 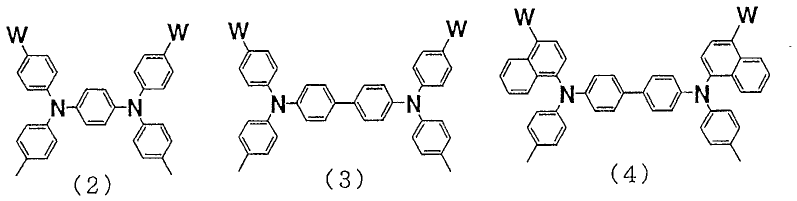 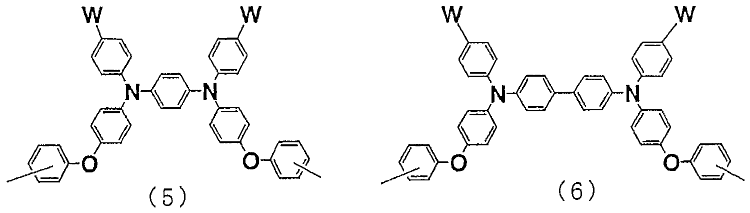 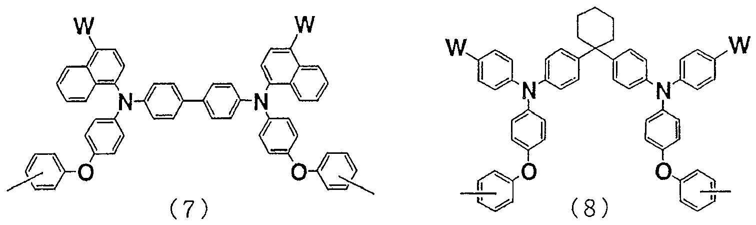 wherein W represents a hydrogen atom, a fluorine atom, a C1 to C5 alkyl group which may have a branched structure, or a C1 to C5 alkoxy group which may have a branched structure,
Q² is at least one divalent organic group selected from the following formula (18) to (20): 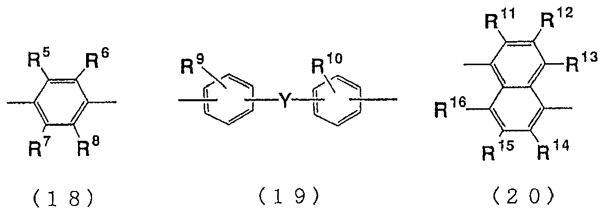 wherein R⁵ to R¹⁶ each independently represent a hydrogen atom, a fluorine atom, a C1 to C5 alkyl group which may have a branched structure, or a C1 to C5 alkoxy group which may have a branched structure, Y each independently represents a single bond, -O-, -S-, -C(O)NH-, -NHC(O)-, a C1 to C5 alkylene group which may have a branched structure, or a C1 to C5 alkylenedioxo group which may have a branched structure, q stands for a positive integer of not smaller than 1,
m¹ and m² each independently stand for an integer not smaller than 1, and satisfy m¹/(m¹+m²) ≥ 0.2;
wherein the varnish does not contain a charge -transporting material composed of oligoaniline derivatives having a number average molecular weight of from 250 to 5,000.

8. The use of claim 7, wherein said polyimide precursor is represented by the formula (17).

9. The use of claim 8, wherein Q¹ is a divalent organic group represented by the formula (6) in which W represents a hydrogen atom, and Q² is a divalent organic group represented by the formula (18) in which R⁵ to R⁸ represent a hydrogen atom.

## Patentansprüche

1. Ladungstransportierender Lack, der eine Lösung oder Dispersion eines ladungstransportierenden Materials oder eines landungstransportierenden organischen Materials und zumindest eines ladungstransportierenden Polymers in zumindest einem Lösungsmittel umfasst, wobei das ladungstransportierende Material aus einem landungstransportierenden Oligoanilin-Derivat mit einer zahlenmittleren Molekulargewicht von 250 bis 5.000 besteht, wobei das ladungstransportierende organische Material aus dem ladungstransportierenden Material und einem ladungsaufnehmenden Dotierungsmaterial besteht,
worin das ladungstransportierende Material ein durch die nachstehende Formel (21) dargestelltes Oligoanilin-Derivat oder ein Chinondiimin-Derivat ist, das ein Oxidationsprodukt der Formel (21) ist: 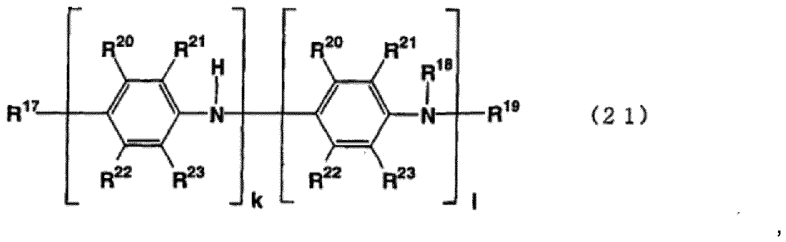 worin R¹⁷, R¹⁸ und R¹⁹ jeweils unabhängig voneinander für ein Wasserstoffatom, eine einwertige Kohlenwasserstoffgruppe oder eine Organoxygruppe stehen, R²⁰ bis R²² jeweils unabhängig voneinander für ein Wasserstoffatom, eine Hydroxylgruppe, eine einwertige Kohlenwasserstoffgruppe, eine Organoxygruppe, eine Acylgruppe oder eine Sulfongruppe stehen und k und l jeweils unabhängig voneinander für eine ganze Zahl, die nicht kleiner ist als 1, stehen und für sie gilt: k + l ≤ 20,
und das ladungstransportierende Polymer ein durch die nachstehende Formel (9) dargestellter Polyimidvorläufer oder ein durch Anwendung von zyklisierender Wasserabspaltung an dem Polyimidvorläufer erhaltenes Polyimid ist: 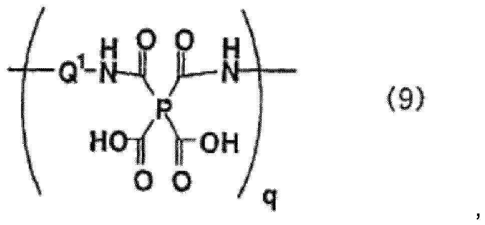 worin P zumindest eine aus den nachstehenden Formeln (10) bis (16) ausgewählte, vierwertige organische Gruppe ist: 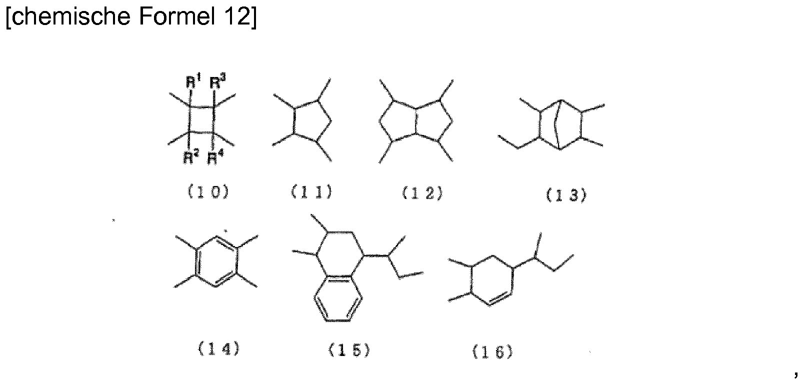 worin in der Formel (10) R¹ bis R⁴ jeweils unabhängig voneinander für ein Wasserstoffatom, ein Fluoratom, eine C₁₋₅-Alkylgruppe, die eine verzweigte Struktur aufweisen kann, oder eine C₁₋₅-Alkoxygruppe, die eine verzweigte Struktur aufweisen kann, stehen,
Q¹ zumindest eine aus den Formeln (2) bis (8) ausgewählte, zweiwertige organische Gruppe ist: 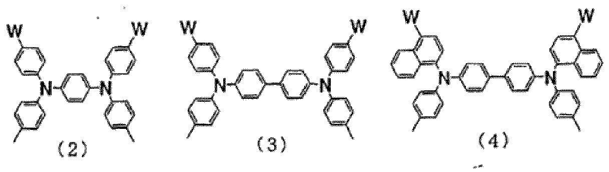 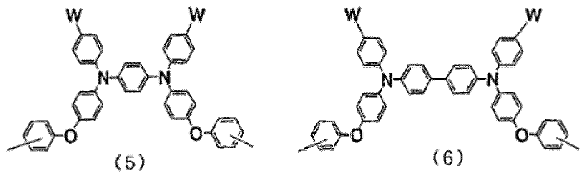 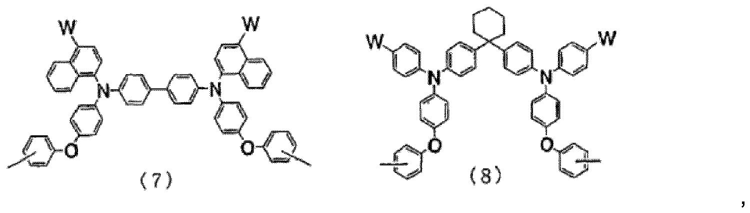 worin W für ein Wasserstoffatom, ein Fluoratom, eine C₁₋₅-Alkylgruppe, die eine verzweigte Struktur aufweisen kann, oder eine C₁₋₅-Alkoxygruppe, die eine verzweigte Struktur aufweisen kann, steht
und q für eine positive ganze Zahl, die nicht kleiner ist als 1, steht;
mit der Maßgabe, dass der Polyimidvorläufer kein von der nachstehenden Formel (17) dargestellter ist: 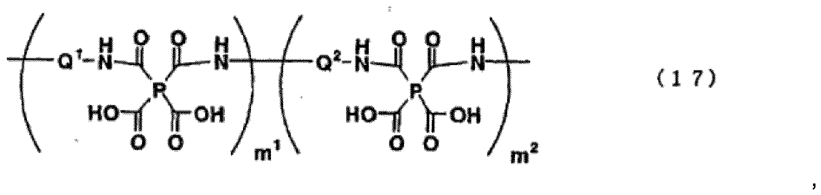 worin P und Q¹ der oben angeführten Definition entsprechen und Q² zumindest eine aus den nachstehenden Formeln (18) bis (20) ausgewählte zweiwertige Gruppe ist: 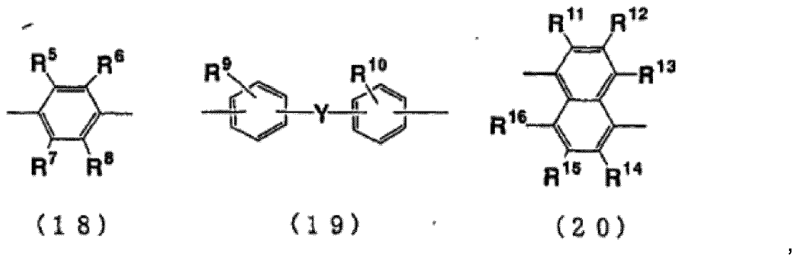 worin R⁵ bis R¹⁶ jeweils unabhängig voneinander für ein Wasserstoffatom, ein Fluoratom, eine C₁₋₅-Alkylgruppe, die eine verzweigte Struktur aufweisen kann, oder eine C₁₋₅-Alkoxygruppe, die eine verzweigte Struktur aufweisen kann, stehen, Y jeweils für eine Einfachbindung, -O-, -S-, -C(O)NH-, -NHC(O)-, eine C₁₋₅-Alkylengruppe, die eine verzweigte Struktur aufweisen kann, oder eine C₁₋₅-Alkylendioxogruppe, die eine verzweigte Struktur aufweisen kann, steht und m¹ und m² jeweils unabhängig voneinander für eine ganze Zahl, die nicht kleiner ist als 1, stehen und für sie gilt: m¹/(m¹ + m²) ≥ 0,2.

2. Ladungstransportierender Lack nach Anspruch 1, worin P eine durch Formel (10) dargestellte, vierwertige organische Gruppe ist und Q¹ eine durch Formel (6) dargestellte, zweiwertige organische Gruppe ist.

3. Ladungstransportierender Lack nach Anspruch 2, worin R¹ bis R⁴ und W für ein Wasserstoffatom stehen.

4. Ladungstransportierender Lack nach einem der vorangegangenen Ansprüche, worin der Polyimidvorläufer ein zahlenmittleres Molekulargewicht von 1.000 bis 100.000 aufweist.

5. Ladungstransportierende Dünnschicht, hergestellt unter Verwendung eines ladungstransportierenden Lacks nach einem der Ansprüche 1 bis 4.

6. Organische Elektrolumineszenzvorrichtung mit zumindest einer aus einer ladungstransportierenden Dünnschicht nach Anspruch 5 gebildeten Schicht.

7. Verwendung eines Lackes, der eine Lösung oder Dispersion eines ladungstransportierenden Polymers zur Herstellung einer ladungstransportierenden Dünnschicht umfasst, wobei das ladungstransportierende Polymer einen durch die nachstehende Formel (9) oder (17) dargestellten Polyimidvorläufer oder ein durch Anwendung von zyklisierender Wasserabspaltung an dem Polyimidvorläufer erhaltenes Polyimid umfasst: 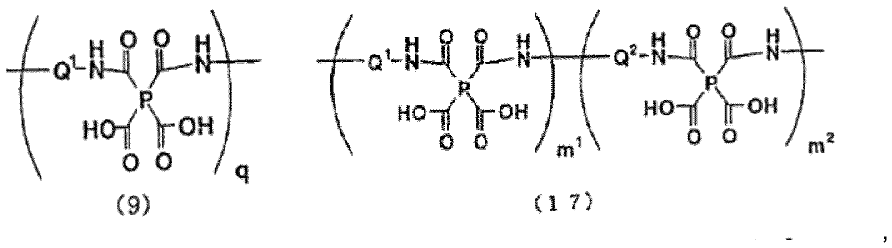 worin P zumindest eine aus den nachstehenden Formeln (10) bis (13), (15) und (16) ausgewählte, vierwertige organische Gruppe ist: 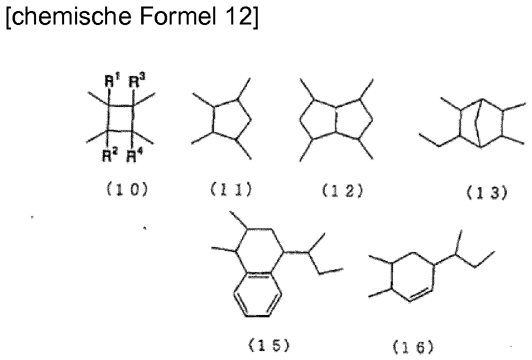 worin in der Formel (10) R¹ bis R⁴ jeweils unabhängig voneinander für ein Wasserstoffatom, ein Fluoratom, eine C₁₋₅-Alkylgruppe, die eine verzweigte Struktur aufweisen kann, oder eine C₁₋₅-Alkoxygruppe, die eine verzweigte Struktur aufweisen kann, stehen,
Q¹ zumindest eine aus den Formeln (2) bis (8) ausgewählte, zweiwertige organische Gruppe ist: 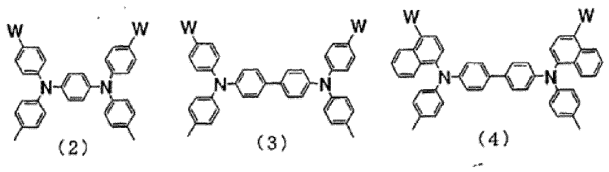 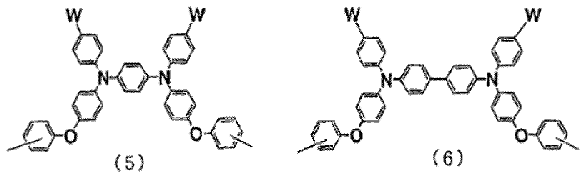 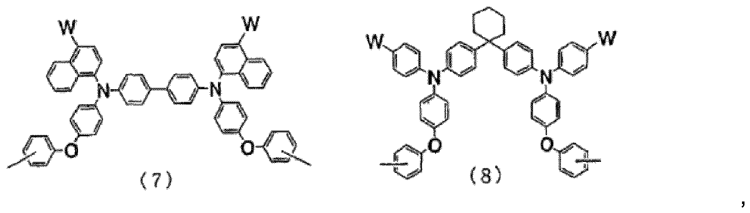 worin W für ein Wasserstoffatom, ein Fluoratom, eine C₁₋₅-Alkylgruppe, die eine verzweigte Struktur aufweisen kann, oder eine C₁₋₅-Alkoxygruppe, die eine verzweigte Struktur aufweisen kann, steht.
Q² zumindest eine aus den nachstehenden Formeln (18) bis (20) ausgewählte, zweiwertige organische Gruppe ist: 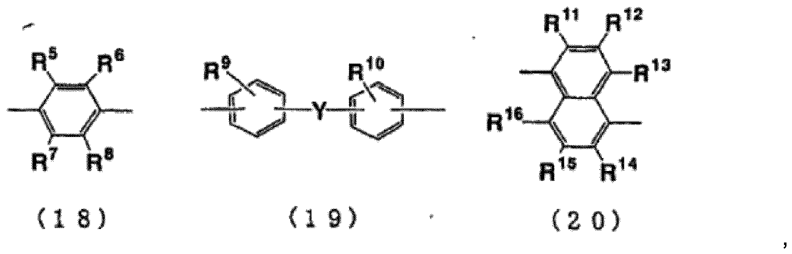 worin R⁵ bis R¹⁶ jeweils unabhängig voneinander für ein Wasserstoffatom, ein Fluoratom, eine C₁₋₅-Alkylgruppe, die eine verzweigte Struktur aufweisen kann, oder eine C₁₋₅-Alkoxygruppe, die eine verzweigte Struktur aufweisen kann, stehen, Y jeweils für eine Einfachbindung, -O-, -S-, -C(O)NH-, -NHC(O)-, eine C₁₋₅-Alkylengruppe, die eine verzweigte Struktur aufweisen kann, oder eine C₁₋₅-Alkylendioxogruppe, die eine verzweigte Struktur aufweisen kann, steht,
q für eine positive ganze Zahl, die nicht kleiner ist als 1, steht,
und m¹ und m² jeweils unabhängig voneinander für eine ganze Zahl, die nicht kleiner ist als 1, stehen und für sie gilt: m¹ / (m¹ + m²) ≥ 0,2;
worin der Lack kein aus Oligoanilinderivaten mit einem zahlenmittleren Molekulargewicht von 250 bis 5.000 bestehendes ladungstransportierendes Material enthält.

8. Verwendung nach Anspruch 7, worin der Polyimidvorläufer durch die Formel (17) dargestellt ist.

9. Verwendung nach Anspruch 8, worin Q¹ eine durch die Formel (6) dargestellte, zweiwertige organische Gruppe ist, worin W für ein Wasserstoffatom steht, und Q² eine durch die Formel (18) dargestellte, zweiwertige organische Gruppe ist, worin R⁵ bis R⁸ jeweils für ein Wasserstoffatom stehen.

## Revendications

1. Vernis transporteur de charges comprenant une solution ou dispersion d'un matériau transporteur de charges ou d'un matériau organique transporteur de charges et d'au moins un polymère transporteur de charges dans au moins solvant, ledit matériau transporteur de charges étant composé d'un dérivé d'oligoaniline transporteur de charges ayant une masse moléculaire moyenne en nombre de 250 à 5 000, ledit matériau organique transporteur de charges étant composé dudit matériau transporteur de charges et d'un matériau dopant accepteur de charges,
dans lequel ledit matériau transporteur de charges est un dérivé d'oligoaniline représenté par la formule (21) suivante ou un dérivé de quinonediimine qui est un produit d'oxydation de la formule (21) : 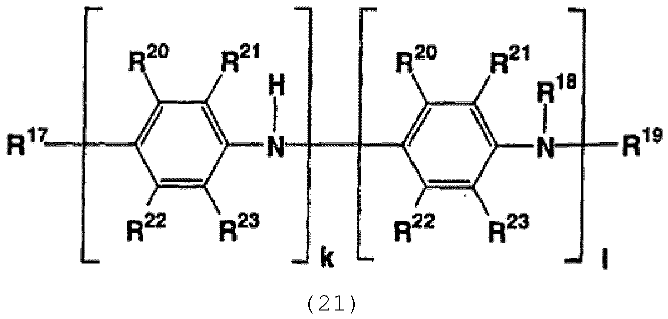 où chacun de R¹⁷, R¹⁸ et R¹⁹ représente indépendamment un atome d'hydrogène, un groupe hydrocarboné monovalent ou un groupe organoxy, chacun de R²⁰ à R²³ représente indépendamment un atome d'hydrogène, un groupe hydroxyle, un groupe hydrocarboné monovalent, un groupe organoxy, un groupe acyle ou un groupe sulfone, et chacun de k et 1 est indépendamment un entier non inférieur à 1 et satisfaisant à k+1 ≤ 20,
ledit polymère transporteur de charges étant un précurseur de polyimide représenté par la formule (9) suivante ou un polyimide obtenu par l'opération consistant à soumettre ledit précurseur de polyimide à une cyclodéshydratation : 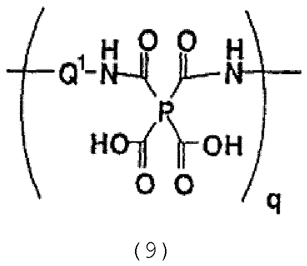 où P est au moins un groupe organique tétravalent choisi parmi les formules (10) à (16) suivantes : 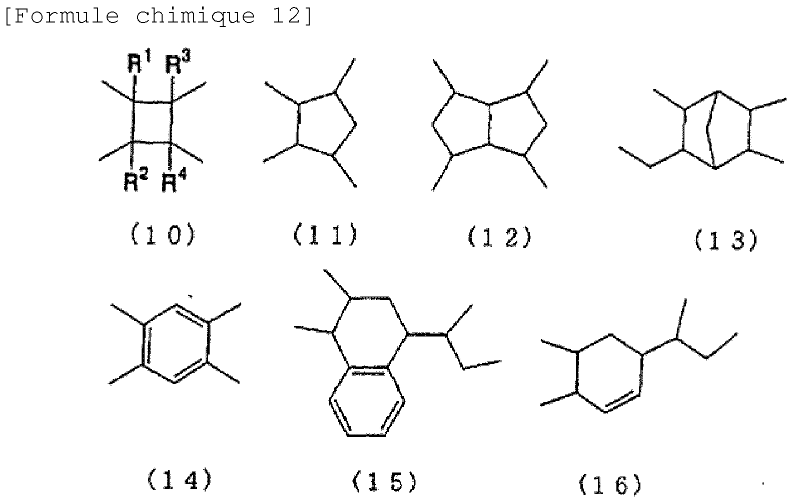 où, dans la formule (10), chacun de R¹ à R⁴ représente indépendamment un atome d'hydrogène, un atome de fluor, un groupe alkyle en C₁ à C₅ pouvant avoir une structure ramifiée, ou un groupe alcoxy en C₁ à C₅ pouvant avoir une structure ramifiée,
Q¹ est au moins un groupe organique divalent choisi parmi les formules (2) à (8) 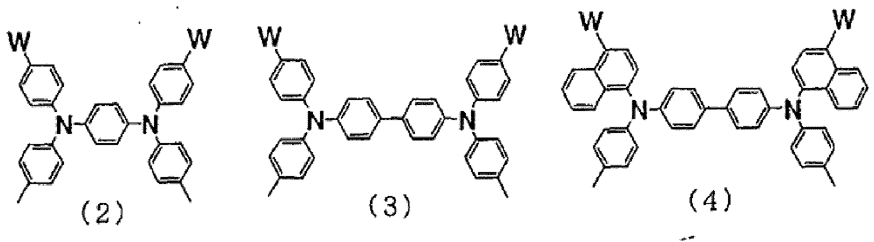 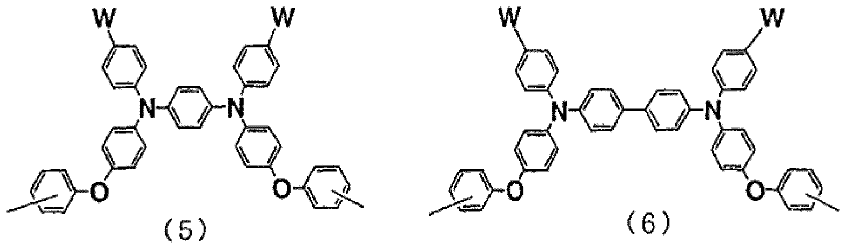 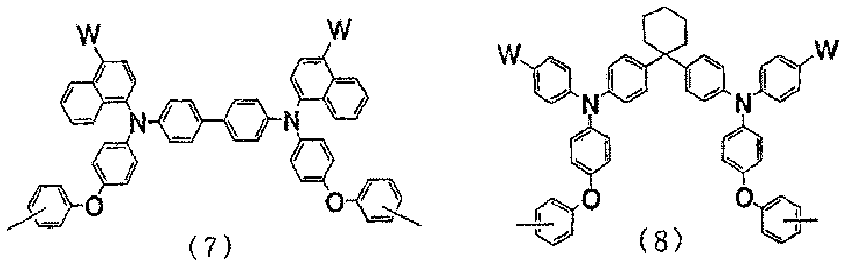 où W représente un atome d'hydrogène, un atome de fluor, un groupe alkyle en C₁ à C₅ pouvant avoir une structure ramifiée, ou un groupe alcoxy en C₁ à C₅ pouvant avoir une structure ramifiée,
et q est un entier positif non inférieur à 1 ;
à la condition que ledit précurseur de polyimide ne soit pas représenté par la formule (17) suivante : 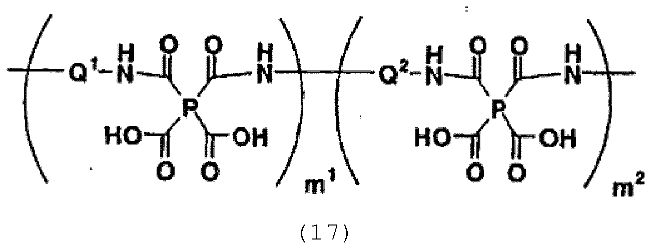 dans laquelle P et Q¹ sont tels que définis ci-dessus, et Q² est au moins un groupe organique divalent choisi parmi les formules (18) à (20) suivantes : 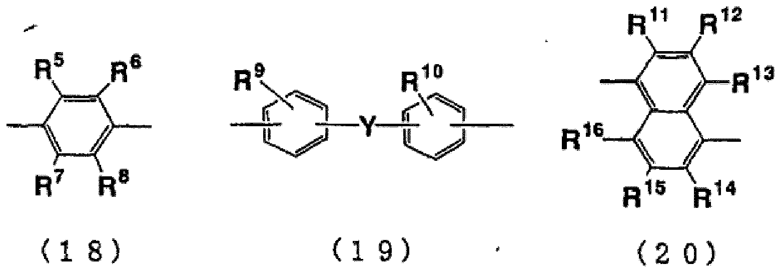 où chacun de R⁵ à R¹⁶ représente indépendamment un atome d'hydrogène, un atome de fluor, un groupe alkyle en C₁ à C₅ pouvant avoir une structure ramifiée, ou un groupe alcoxy en C₁ à C₅ pouvant avoir une structure ramifiée, chaque Y représente indépendamment une liaison simple, -O-, -S-, -C(O)NH-, -NHC(O)-, un groupe alkylène en C₁ à C₅ pouvant avoir une structure ramifiée, ou un groupe alkylènedioxo en C₁ à C₅ pouvant avoir une structure ramifiée, et
chacun de m¹ et m² est indépendamment un entier non inférieur à 1, et satisfaisant à m¹/ (m¹+m²) ≥ 0,2.

2. Vernis transporteur de charges selon la revendication 1, dans lequel ledit P est un groupe organique tétravalent représenté par la formule (10) et Q¹ est un groupe organique divalent représenté par la formule (6).

3. Vernis transporteur de charges selon la revendication 2, dans lequel R¹ à R⁴ et W représentent des atomes d'hydrogène.

4. Vernis transporteur de charges selon l'une quelconque des revendications précédentes, dans lequel ledit précurseur de polyimide a une masse moléculaire moyenne en nombre de 1 000 à 100 000.

5. Film mince transporteur de charges préparé par utilisation d'un vernis transporteur de charges selon l'une quelconque des revendications 1 à 4.

6. Dispositif électroluminescent organique ayant au moins une couche formée d'un film mince transporteur de charges selon la revendication 5.

7. Utilisation d'un vernis comprenant une solution ou dispersion d'un polymère transporteur de charges pour préparer un film mince transporteur de charges, ledit polymère transporteur de charges comprenant un précurseur de polyimide représenté par l'une des formules (9) et (17) suivantes, ou un polyimide obtenu par l'opération consistant à soumettre ledit précurseur de polyimide à une cyclodéshydratation : 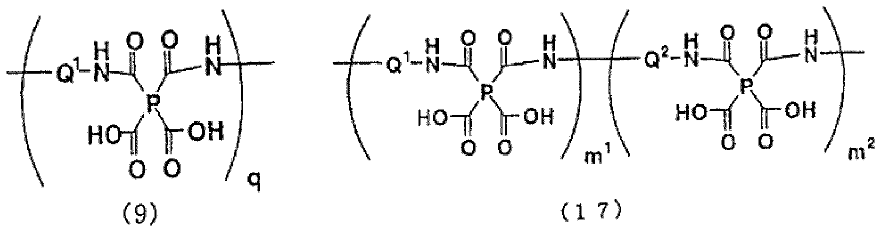 où P est au moins un groupe organique tétravalent choisi parmi les formules (10), (13), (15) et (16) suivantes : 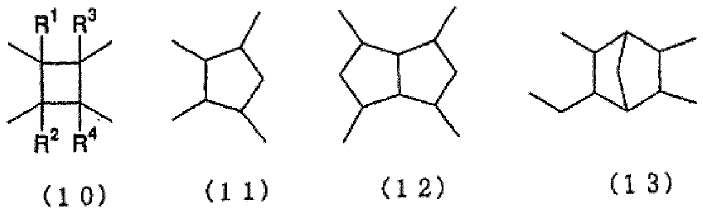 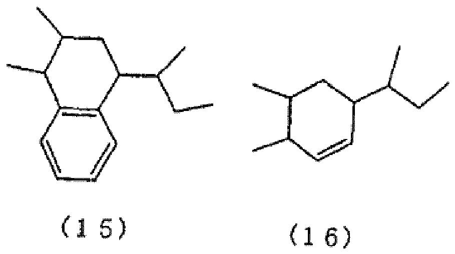 où, dans la formule (10), chacun de R¹ à R⁴ représente indépendamment un atome d'hydrogène, un atome de fluor, un groupe alkyle en C₁ à C₅ pouvant avoir une structure ramifiée, ou un groupe alcoxy en C₁ à C₅ pouvant avoir une structure ramifiée,
Q¹ est au moins un groupe organique divalent choisi parmi les formules (2) à (8) suivantes : 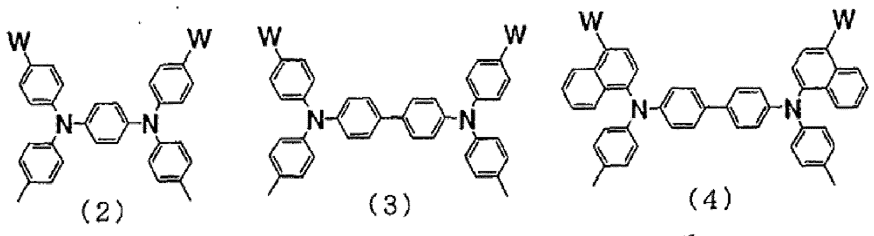 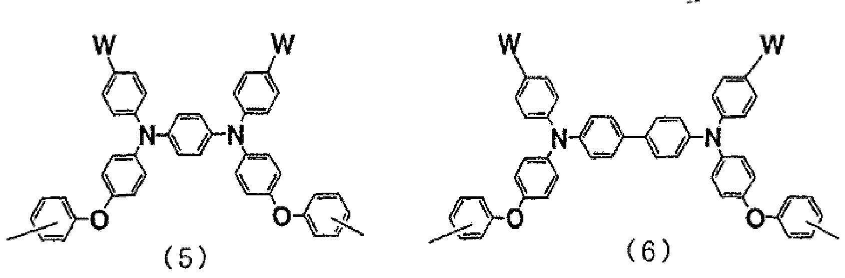 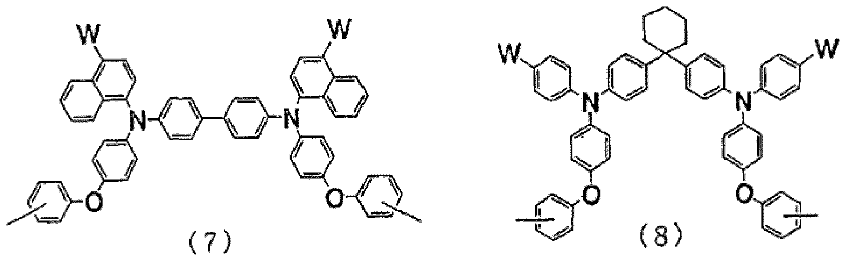 où W représente un atome d'hydrogène, un atome de fluor, un groupe alkyle en C₁ à C₅ pouvant avoir une structure ramifiée, ou un groupe alcoxy en C₁ à C₅ pouvant avoir une structure ramifiée,
Q² est au moins un groupe organique divalent choisi parmi les formules (18) à (20) suivantes : 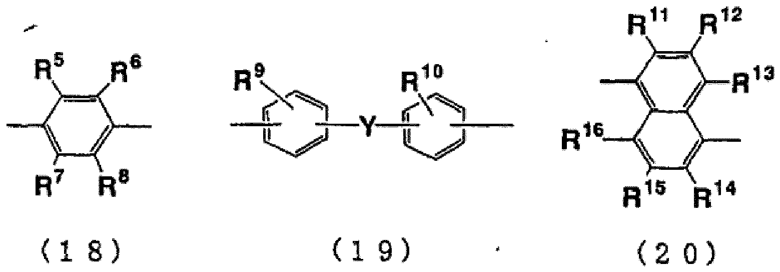 où chacun de R⁵ à R¹⁶ représente indépendamment un atome d'hydrogène, un atome de fluor, un groupe alkyle en C₁ à C₅ pouvant avoir une structure ramifiée, ou un groupe alcoxy en C₁ à C₅ pouvant avoir une structure ramifiée, chaque Y représente indépendamment une liaison simple, -O-, -S-, -C(O)NH-, -NHC(O)-, un groupe alkylène en C₁ à C₅ pouvant avoir une structure ramifiée, ou un groupe alkylènedioxo en C₁ à C₅ pouvant avoir une structure ramifiée,
q est un entier positif non inférieur à 1,
chacun de m¹ et m² est indépendamment un entier non inférieur à 1, et satisfaisant à m¹/ (m¹+m²) ≥ 0,2 ;
dans laquelle le vernis ne contient pas de matériau transporteur de charges composé de dérivés d'oligoaniline ayant une masse moléculaire moyenne en nombre de 250 à 5 000.

8. Utilisation selon la revendication 7, dans laquelle ledit précurseur de polyimide est représenté par la formule (17).

9. Utilisation selon la revendication 8, dans laquelle Q¹ est un groupe organique divalent représenté par la formule (6) où W représente un atome d'hydrogène, et Q² est un groupe organique divalent représenté par la formule (18) où R⁵ à R⁸ représentent des atomes d'hydrogène.
